(19) Europäisches Patentamt
European Patent Office
Office européen des brevets

(11) **EP 1 631 091 B1**

(12) **EUROPÄISCHE PATENTSCHRIFT**

(45) Veröffentlichungstag und Bekanntmachung des Hinweises auf die Patenterteilung:
**02.06.2010 Patentblatt 2010/22**

(51) Int Cl.:
*H04N 7/26* (2006.01)      *H03M 7/30* (2006.01)

(21) Anmeldenummer: **05018392.0**

(22) Anmeldetag: **24.08.2005**

(54) **Kodierung mehrerer binärer Eingangsdatenworte in ein Ausgangskodewort**

Coding of a plurality of binary input data words into one codeword

Codage d'une pluralité de mots binaires entrants à un mot binaire sortant

(84) Benannte Vertragsstaaten:
**DE FR GB IT NL**

(30) Priorität: **26.08.2004 DE 102004041418**

(43) Veröffentlichungstag der Anmeldung:
**01.03.2006 Patentblatt 2006/09**

(73) Patentinhaber: **Micronas GmbH**
**79108 Freiburg i. Br. (DE)**

(72) Erfinder:
• **Schu, Markus**
**85435 München (DE)**
• **Rieder, Peter, Dr.**
**81737 München (DE)**
• **Hahn, Marko**
**85579 Neubiberg (DE)**
• **Scheffler, Günter**
**80939 München (DE)**
• **Tuschen, Christian**
**80687 München (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
DE-A1- 10 007 171      US-A- 4 682 152
US-A- 4 870 685      US-A- 5 438 635
US-A- 5 946 652      US-A1- 2003 161 278
US-E1- R E38 279

• KESHI CHEN ET AL: "NEAR-LOSSLESS COMPRESSION OF MEDICAL IMAGES THROUGH ENTROPY-CODED DPCM" IEEE TRANSACTIONS ON MEDICAL IMAGING, IEEE SERVICE CENTER, PISCATAWAY, NJ, US, Bd. 13, Nr. 3, 1. September 1994 (1994-09-01), Seiten 538-548, XP000474144 ISSN: 0278-0062

**Beschreibung**

Die vorliegende Erfindung betrifft ein Verfahren zur Codierung eines ersten und zweiten Datenwortes, um ein codiertes drittes Datenwort zu erhalten. Die Erfindung betrifft insbesondere ein Verfahren zur Codierung zweier Datenworte, die jeweils differentielle Datenwerte, beispielsweise differentielle Luminanzwerte und differentielle Chrominanzwerte, repräsentieren.

In der Bildverarbeitung ist es hinlänglich bekannt, einzelne Bildpunkte eines Bildes jeweils durch mehrere Bildinformationswerte, beispielsweise einen Luminanzwert (Helligkeitswert) und zwei Chrominanzwerte (Farbwerte), zu definieren. Die Übertragung oder Speicherung solcher Bilder erfolgt dabei dadurch, dass die Bildinformationswerte der einzelnen Bildpunkte des Bildes in einer vorgegebenen Reihenfolge auf einen seriellen Datenstrom abgebildet werden, der abgespeichert oder übertragen wird. Bei Bildern im sogenannten YUV-Format sind den einzelnen Bildpunkten ein Y-Wert als Luminanzwert sowie ein U-Wert und ein V-Wert als Chrominanzwerte zugeordnet, wobei abhängig vom speziellen Format, die Anzahl der einem Bild zugeordneten Y-, U- und V-Werte variiert. Beim sogenannten 4:4:4-Format sind zur Darstellung eines Bildes jeweils gleich viele Y-, U- und V-Werte vorhanden, jedem Bildpunkt ist also ein Y-Wert, ein U-Wert und ein V-Wert zugeordnet. Im 4:2:2-Format sind doppelt so viele Y-Werte wie U- und V-Werte vorhanden. Die Übertragung oder Abspeicherung der Werte eines Bildes erfolgt als serielle Datenfolge derart, dass jeder zweite übertragene Datenwert ein Y-Wert ist, auf den abwechselnd ein U-Wert und ein V-Wert folgt (Y1-U1-Y2-V1-Y3-U2...).

Um die Datenübertragungsrate bei der Übertragung von Bild- oder Tondaten zu reduzieren, sind verschiedene Codierungsverfahren bekannt. Ein solches Codierungsverfahren zur Reduktion der Datenrate bei der Übertragung von Bild- oder Tondaten ist das sogenannte DPCM-Verfahren (DPCM = Differenz-Pulse-Code-Modulation), das beispielsweise in Ohm, Jens-Rainer: "Digitale Bildcodierung: Repräsentation, Kompression und Übertragung", Springer, 1995, ISBN 3-540,58579-6, Seiten 246 bis 261, beschrieben ist.

Beim DPCM-Verfahren werden anstelle von Absolutwerten Differenzen jeweils aufeinanderfolgender Werte einer Datenfolge quantisiert und codiert. Davon ausgehend, dass bei der Übertragung von Tondaten oder Bilddaten bei aufeinanderfolgenden Werten, d. h. bei jeweils zwei aufeinanderfolgenden Tondaten repräsentierenden Werten, Helligkeitsdaten repräsentierenden Werten oder Farbdaten repräsentierenden Werte kleine Signalsprünge von Wert zu Wert häufiger auftreten, als große Signalsprünge und dass das Auge beim Quantisieren der Sprünge bei großen Sprüngen toleranter ist, als bei kleineren Signalsprüngen, werden beim DPCM-Verfahren große Differenzwerte gröber quantisiert, während kleinere Differenzwerte feiner quantisiert werden. Die Reduktion der Übertragungsrate ist dabei über die Genauigkeit der Quantisierung einstellbar.

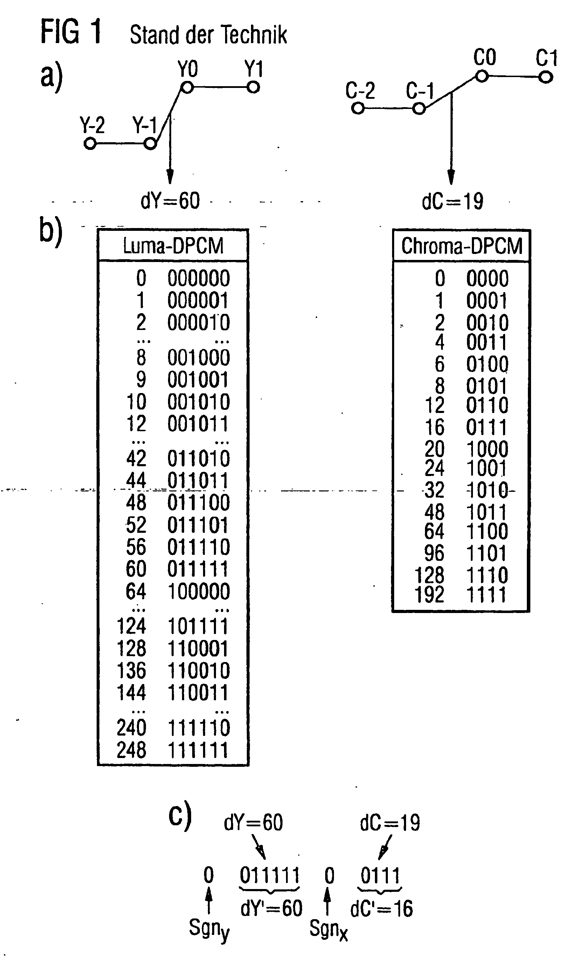

Das DPCM-Verfahren wird nachfolgend für eine Codierung eines Luminanz-Differenzwertes und eines Chrominanz-Differenzwertes anhand von Figur 1 erläutert. Mittels dieses Verfahrens werden Luminanz-Differenzwerte und Chrominanz-Differenzwerte codiert, die jeweils Amplituden zwischen -255 und +255 annehmen können. Für eine fehlerfreie Codierung dieser Werte würden jeweils 9 Bit, nämlich 1 Vorzeichenbit und 8 Datenbit benötigt. Um die Übertragungsrate zu reduzieren, werden bei dem bekannten Verfahren für die Luminanz-Differenzwerte jedoch nur 7 Bit, 1 Vorzeichenbit und 6 Datenbit, und für die Übertragung der Chrominanz-Differenzwerte nur 5 Bit, 1 Vorzeichenbit und 4 Datenbit, zur Verfügung gestellt. Hieraus resultiert eine Reduktion der erforderlichen Übertragungsrate bzw. der erforderlichen Übertragungsbandbreite, unweigerlich jedoch auch ein Informationsverlust bzw. ein aus der Codierung resultierender Fehler.

Die Differenzwerte werden bezugnehmend auf die in Figur 1b dargestellten Codierungstabellen nicht-linear quantisiert, wobei die Quantisierung mit zunehmender Amplitude des zu codierenden Differenzwertes gröber wird. Für die Luminanz-Differenzwerte erfolgt die Quantisierung für Amplitudenwerte zwischen 0 und 10 in Einerschritten, und damit ohne Quantisierungsfehler. Ab einem Amplitudenwert 10 erfolgt die Quantisierung in Zweierschritten, ab einem Amplitudenwert 44 in Viererschritten und ab einem Amplitudenwert von 128 in Achterschritten. Gilt es z. B. einen Luminanz-Differenzwert mit einer Amplitude von 247 zu übertragen, so wird hierfür der Wert 240 codiert und übertragen, woraus ein Quantisierungsfehler von 7 resultiert. Bei Anwendung der in Figur 1b dargestellten Quantisierungs- bzw. Codierungstabelle für Chrominanz-Differenzwerte, welche für die Übertragung von Chrominant-Differenzwerten nur 4 Datenbit zur Verfügung stellt, beträgt der maximale Quantisierungsfehler bei Amplitudenwerten größer als 128 sogar 63, da ab einem Amplitudenwert 128 in 64er-Schritten quantisiert wird.

Die Umsetzung eines Luminanz-Differenzwertes und eines Chrominanz-Differenzwertes auf ein Datenwort der Länge 12 Bit ist für einen Lumminanz-Differenzwert dY = 60 und einen Chrominanz-Differenzwert dC = 19 in Figur 1c dargestellt. Bei dem Verfahren werden neben den zwei Vorzeichenbit, nämlich dem Vorzeichenbit $Sgn_y$ des Luminanz-Differenzwertes dY und dem Vorzeichenbit $Sgn_c$ des Chrominanz-Differenzwertes, die aus der Codierungstabelle zu entnehmenden Codewörter dY' und dC' auf das zu übertragende Codewort abgebildet. Die Übertragung des Luminanz-Differenzwertes dY erfolgt in dem Beispiel ohne Quantisierungsfehler, da der Luminanz-Differenzwert dY = 60 zufällig gerade einem der in der Luminanz-Codierungstabelle angegebenen Intervallgrenzwert entspricht. Für den Chrominanz-Differenzwert dC = 19, der zwischen den in der Chrominanz-Codierungstabelle angegebenen Grenzwerten 16 und 20 liegt, wird der Differenzwert dC' = 16 übertragen, woraus für den Chrominanz-Differenzwert dC ein Quantisierungsfehler von 3 resultiert.

Nachteilig bei dem bekannten Verfahren, bei dem zwei Bildinformationswerte, nämlich ein Luminanz-Differenzwert und ein Chrominanz-Differenzwert, auf ein gemeinsames codiertes Datenwort abgebildet werden, ist, dass die Quantisierungsgenauigkeit von den verwendeten Codierungstabellen abhängig ist, wodurch das Verfahren starr und unflexibel ist.

Die DE 100 07 171 beschreibt ein Verfahren zur Codierung mehrerer Datenworte in einem gemeinsamen codierten Datenwort. Bei diesem Verfahren wird für jedes Datenwort zunächst die Anzahl der signifikanten Ziffern ermittelt und jedem Datenwort eine von der Anzahl dieser Ziffern abhängige Signifikanzinformation zugeordnet. Die Signifikanzinformationen werden dann in einem codierten Datenwort abgelegt und die einzelnen Datenbits der Datenworte werden unter Berücksichtigung der Signifikanzinformation auf das codierte Datenwort abgebildet.

Die US 5,438,635 beschreibt ein Verfahren zur differenziellen Codierung von drei Datenwerten, die jeweils Farbwerte eines Bildpunkts eines Videobilds repräsentieren.

Ziel der vorliegenden Erfindung ist es, ein Verfahren zur Codierung wenigstens eines, eine Anzahl Datenbits umfassenden ersten Datenwortes und eines, eine Anzahl Datenbits umfassenden zweiten Datenwortes in ein eine Anzahl Datenbits umfassendes codiertes Datenwort zur Verfügung zu stellen, das eine flexiblere Codierung gewährleistet, das zumindest für einige Wertepaare der ersten und zweiten Datenworte geringere Quantisierungsfehler bei der Codierung gewährleistet und das einfach implementierbar ist.

Dieses Ziel wird durch ein Verfahren nach Anspruch 1 gelöst. Vorteilhafte Ausgestaltungen dieses Verfahrens sind Gegenstand der Unteransprüche.

Gegenstand der Erfindung ist ein Verfahren zur Codierung eines ersten Datenwertes und wenigstens eines zweiten Datenwertes in ein codiertes Datenwort, das folgende Verfahrensschritte umfasst:

- Ermitteln eines ersten Approximationswertes, dem ein erstes Codewort zugeordnet ist, für den ersten Datenwert, und eines zweiten Approximationswertes, dem ein zweites Codewort zugeordnet ist, für den zweiten Datenwert,

- Abbilden des ersten Codewortes auf einen ersten Datenabschnitt des codierten Datenwortes und Abbilden des zweiten Codewortes auf einen zweiten Datenabschnitt des codierten Datenwortes,

- Ermitteln einer ersten Differenz zwischen dem ersten Datenwert und dem ersten Approximationswert und Ermitteln einer zweiten Differenz zwischen dem zweiten Datenwert und dem zweiten Approximationswert und wenigstens teilweises Abbilden eines den ersten Differenzwert repräsentierenden ersten Differenz-Datenworts und/oder eines den zweiten Differenzwert repräsentierenden zweiten Differenz-Datenwortes auf wenigstens einen zusätzlichen Datenabschnitt des codierten Datenwortes.

Vorzugsweise ist der erste Datenwert durch ein eine Anzahl Datenbits umfassendes erstes Datenwort repräsentiert und der zweite Datenwert durch ein eine Anzahl Datenbits umfassendes zweites Datenwort repräsentiert. Ein erster Approximationswert wird dann vorzugsweise dadurch gebildet, dass die Position des für den Wert des ersten Datenwortes höchsten relevanten Datenbits ermittelt und die Zweierpotenz dieser Bitposition gebildet wird. Entsprechend wird ein zweiter vorzugsweise dadurch gebildet, dass die Position des für den Wert des zweiten Datenwortes höchsten relevanten Datenbits ermittelt und die Zweierpotenz dieser Bitposition gebildet wird.

Vorzugsweise ist dabei jeder Datenbitposition des ersten Datenwortes wenigstens ein für diese Bitposition individuelles erstes Codewort und jeder Datenbitposition eines zweiten Datenwortes wenigstens ein für diese Bitposition individuelles zweites Codewort zugeordnet und jeder Bitposition des ersten Datenwortes eine erste Rangfolgenummer und jeder Bitposition des zweiten Datenwortes eine zweite Rangfolgenummer zugeordnet. Das Verfahren umfasst dabei folgende weitere Verfahrensschritte:

    a) Ermitteln der für den Wert des ersten Datenwortes höchsten relevanten Bitposition und Abbilden des dieser Bitposition zugeordneten ersten Codewortes auf einen ersten Datenabschnitt des codierten Datenwortes,

    b) Ermitteln der für den Wert des zweiten Datenwortes höchsten relevanten Bitposition und Abbilden des dieser Bitposition zugeordneten zweiten Codewortes auf einen zweiten Datenabschnitt des codierten Datenwortes,

    c) Abbilden des Datenbits wenigstens einer bezogen auf die höchste relevante Bitposition niedrigeren Bitposition des ersten oder zweiten Datenwortes auf wenigstens einen zusätzlichen Datenabschnitt des codierten Datenwortes.

Das Abbilden des Datenbits wenigstens einer bezogen auf die höchste relevante Bitposition niedrigeren Bitposition entspricht dabei der Abbildung der ersten und/oder zweiten Differenz auf den zusätzlichen Datenabschnitt des codierten Datenwortes.

Vorzugsweise werden bei diesem Verfahren die Rangfolgenummern der höchsten relevanten Bitpositionen des ersten und zweiten Datenwortes verglichen und abhängig von diesem Vergleich wird ein Datenbit des ersten oder zweiten Datenwortes auf den zusätzlichen Datenabschnitt abgebildet. Die Rangfolgenummern der einzelnen Bitpositionen können dabei insbesondere abhängig von einem fiktiven Quantisierungsfehler gewählt sein, der vorliegen würde, wenn für das erste und zweiten Datenwort jeweils nur die Information über die höchste relevante Bitposition codiert bzw. übertragen würde. Vorzugsweise wird das nächstrelevante Datenbit desjenigen der ersten und zweiten Datenwörter als nächstes codiert, für welches der Quantisierungsfehler größer wäre.

Das erste und/oder zweite Datenwort können neben den Datenbits selbstverständlich auch ein Vorzeichen umfassen. Diese Vörzeichenbits können neben den ersten und zweiten Codewörtern auf das codierte Datenwort abgebildet werden. Darüber hinaus besteht auch die Möglichkeit, das Vorzeichenbit bei der Erzeugung der ersten und zweiten Codewörter, die auf das codierte Datenwort abgebildet werden, zu berücksichtigen. So können jeder Bitposition des ersten Datenwortes zwei erste Codewörter und jeder Bitposition des zweiten Datenwortes zwei zweite Codewörter zugeordnet sein, die jeweils die Bitposition und das Vorzeichen berücksichtigen.

Vorzugsweise umfasst das codierte Datenwort neben den ersten und zweiten Codewörtern und gegebenenfalls den Vorzeichenbits mehrere zusätzliche Datenabschnitte, denen Datenbits des ersten und/oder zweiten Datenwortes gemäß folgenden Verfahrensschritten zugeordnet werden:

c1) Ermitteln der Rangfolgenummer der Bitposition des zuletzt auf das codierte Datenwort abgebildeten Datenbits des ersten Datenwortes und Ermitteln der Rangfolgenummer des zuletzt auf das codierte Datenwort abgebildeten Datenbits des zweiten Datenwortes,

c2) Vergleichen der Rangfolgenummern,

c3) Auswählen eines der ersten und zweiten Datenwörter abhängig von dem Vergleich der Rangfolgenummern und Abbilden eines Datenbits aus diesem ausgewählten Datenwort auf das codierte Datenwort,

c4) Wiederholen der Verfahrensschritte c1) bis c3) solange, bis alle zusätzlichen Datenbits des codierten Datenwortes besetzt sind.

Vorzugsweise wird bei diesem Verfahren jeweils das Datenwort ausgewählt, dessen zuletzt auf das codierte Datenwort abgebildete Datenbit bzw. dessen relevantestes der bisher auf das codierte Datenwort abgebildeten Datenbits die höhere Rangfolgenummer hat. Bei Gleichheit der Rangfolgenummern wird dabei ein Datenbit eines fest vorgegebenen der beiden Datenwörter auf den zusätzlichen Datenabschnitt des codierten Datenwortes abgebildet. Sind die zu codierenden ersten und zweiten Datenwörter beispielsweise ein einen Luminanzwert repräsentierendes Datenwort und ein einen Chrominanzwert repräsentierendes Datenwort so wird bei gleichen Rangfolgenummern vorzugsweise ein Datenbit des Luminanzwertes auf das codierte Datenwort abgebildet, um den Codierungsfehler des Luminanzwertes zu reduzieren. Dem liegt die Erkenntnis zugrunde, dass Codierungsfehler des Luminanzwertes für den Betrachter stärker ins Gewicht fallen als Codierungsfehler des Chrominanzwertes und daher bevorzugt zu reduzieren sind.

Insbesondere besteht die Möglichkeit, einem der ersten und zweiten Datenworte eine Codierungspriorität zuzuweisen, wobei in Verfahrensschritt c3) stets das Datenwort mit der Codierungspriorität ausgewählt wird, um ein weiteres Datenbit dieses Datenwortes zu codieren, wenn die Differenz zwischen der Rangfolgenummer des zuletzt aus diesem Datenwort abgebildeten Datenbits und des zuletzt aus dem anderen Datenwort abgebildeten Datenbits kleiner als ein vorgegebener Wert ist.

Die Rangfolgenummern der Bitpositionen der einzelnen Datenwörter sind beispielsweise so gewählt, dass sie von der Nummer der Bitposition abhängig sind und eine aufsteigende Nummernfolge beginnend mit dem am wenigsten relevanten Bit (LSB = Least Significant Bit) des jeweiligen Datenwortes bilden.

Die nach dem erfindungsgemäßen Verfahren codierten Datenworte repräsentieren insbesondere differentielle Datenwerte, insbesondere einen Luminanz-Differenzwert und einen Chrominanz-Differenzwert.

Die den einzelnen Bitpositionen der ersten und zweiten Datenworte zugeordneten Codewörter können so gewählt sein, dass sie jeweils eine gleiche Anzahl Codebits umfassen. Selbstverständlich besteht jedoch auch die Möglichkeit, die Codewörter so zu wählen, dass die einzelnen Codewörter unterschiedlich lang sind, wodurch abhängig von der zu codierenden höchsten relevanten Bitposition der einzelnen Datenworte unterschiedlich viele zusätzliche Datenabschnitte für die Codierung weiterer Datenbits zur Verfügung stehen.

Das vorliegende Verfahren wird nachfolgend anhand von Figuren näher erläutert.

Figur 1    veranschaulicht ein DPCM-Verfahren zur Codierung zweier differentieller Datenwörter auf ein codiertes Datenwort nach dem Stand der Technik.

Figur 2    veranschaulicht die Datenlänge des ersten und zweiten Datenwortes und des codierten Datenwortes.

Figur 3    veranschaulicht eine Codierungstabelle mit ersten Codewörtern, die jeweils einer Bitposition des ersten Datenwortes zugeordnet sind.

Figur 4    veranschaulicht eine Codierungstabelle mit zweiten Codewörtern, die jeweils einer Bitposition des zweiten Datenwortes zugeordnet sind.

Figur 5    veranschaulicht die Codierung eines ersten und zweiten Datenwortes auf das codierte Datenwort unter Verwendung der in den Figuren 3 und 4 dargestellten Codierungstabellen gemäß dem erfindungsgemäßen Verfahren.

Figur 6    erläutert die empfängerseitige Rekonstruktion übertragener Datenwörter und des aus der Codierung resultierenden Fehlers.

Figur 7    veranschaulicht ein weiteres Beispiel zur Codierung zweier Datenwörter auf ein codiertes Datenwort (Figur 7a) und die empfängerseitige Rekonstruktion (Figur 7b).

Figur 8    veranschaulicht die Codierung vorzeichenbehafteter erster und zweiter Datenwörter auf ein codiertes Datenwort.

Figur 9    zeigt eine mehrere aufeinanderfolgende Datenwerte umfassende Datenwertfolge.

Figur 10    zeigt zusammenfassend eine Codierung zweier differentieller Datenwörter auf ein codiertes Datenwort.

Figur 11    zeigt zusammenfassend eine Codierung zweier Datenwörter auf ein codiertes Datenwort bei einer weiteren Ausführungsform des erfindungsgemäßen Verfahrens.

Figur 12    zeigt eine weitere Tabelle mit Approximationswerten, deren Rangfolgenummer und deren zugeordnetem Codewort.

In den Figuren bezeichnen, sofern nicht anders angegeben, gleiche Bezugzeichen gleiche Signale und Variablen mit gleicher Bedeutung.

Ziel der vorliegenden Erfindung ist es, einen ersten und wenigstens einen zweiten Datenwert auf ein codiertes Datenwort abzubilden, um das codierte Datenwort zu übertragen.

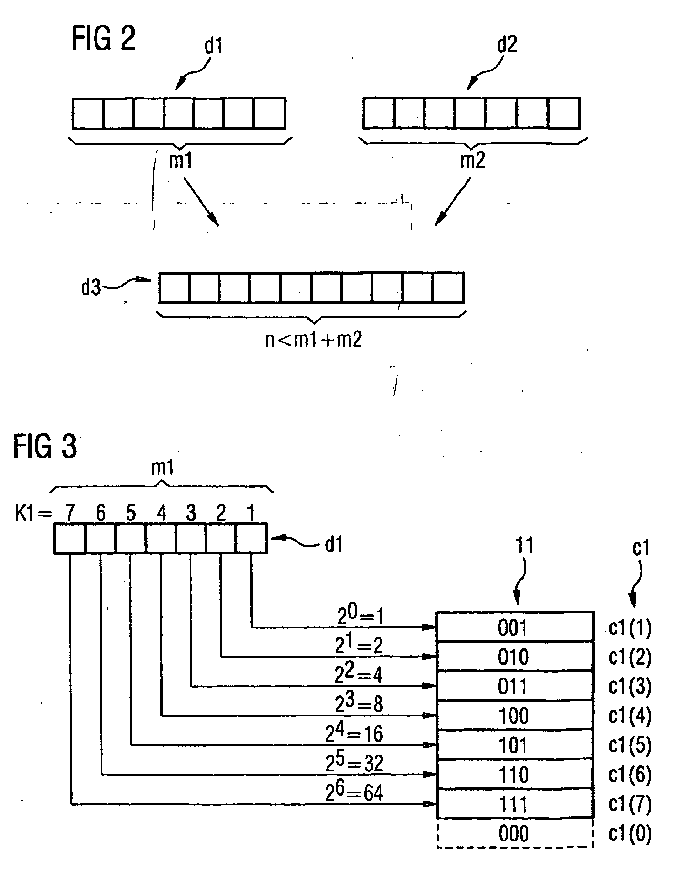

In dem Beispiel gemäß Figur 2 ist der erste Datenwert durch ein erstes Datenwort $d_1$ mit einer ersten Anzahl $m_1$ Datenbits, und der zweite Datenwert durch ein zweites Datenwort $d_2$ mit einer zweiten Wortlänge $m_2$ repräsentiert. Das codiertes Datenwort $d_3$ besitzt eine Wortlänge $n$, wobei die Wortlänge $n$ dieses codierten Datenwortes $d_3$ vorzugsweise kleiner ist als die Summe der ersten und zweiten Wortlängen $m_1$, $m_2$, so dass $n < m_1 + m_2$ gilt.

In dem in Figur 2 gewählten Beispiel gilt für die ersten und zweiten Wortlängen $m_1 = m_2 = 7$, so dass das erste und das zweite Datenwort $d_1$, $d_2$ jeweils Dezimalwerte zwischen 0 und $127 (=2^7-1)$ repräsentieren können. Die Wortlänge des codierten Datenwortes $d_3$ beträgt in dem Beispiel $n = 10$.

Bezugnehmend auf Figur 3 ist vorgesehen, jeder der sieben Bitpositionen $k_1$ des ersten Datenwortes $d_1$ ein erstes Codewort $c_1$ zuzuordnen, das in einer ersten Codetabelle 11 abgelegt ist. Figur 3 veranschaulicht die Zuordnung der einzelnen ersten Codewörter $c_1(1)$ bis $c_1(7)$ zu den einzelnen Bitpositionen. Der ersten Bitposition, die in dem Beispiel das am wenigsten relevante Datenbit (LSB) des ersten Datenworte $d_1$ umfasst, ist in

dem Beispiel das erste Codewort $c_1(1) = 001$ zugeordnet. Die einzelnen Codewörter umfassen drei Datenbits und sind in dem Ausführungsbeispiel so gewählt, dass der Zahlenwert des binären Codewortes jeweils der Bitposition $k_1$ entspricht. Selbstverständlich könnten die binären Codewörter 001 bis 111 den einzelnen Bitpositionen auch beliebig zugeordnet werden. Wesentlich ist hierbei nur, dass jeder Bitposition $k_1$ durch die Codierungstabelle 11 ein individuelles, das heißt eindeutiges, erstes Codewort $c_1$ zugeordnet ist. Zum besseren Verständnis des im Weiteren noch erläuterten Codierungsverfahrens ist in Figur 3 neben der Codetabelle auch angegeben, welcher dezimale Zahlenwert durch die jeweilige Bitposition des ersten Datenwortes D1 repräsentiert ist.

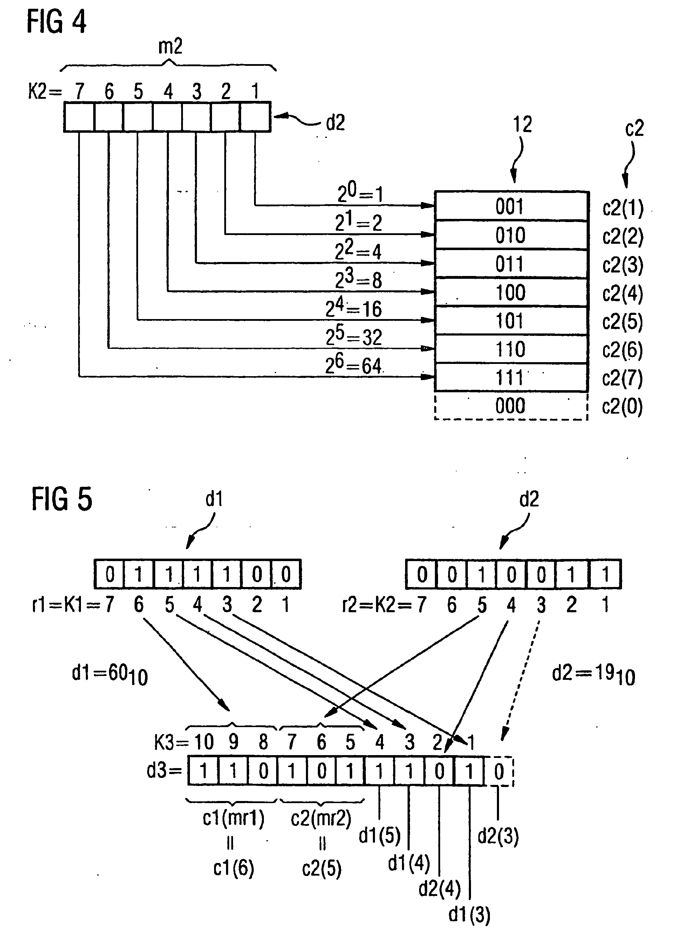

Bezugnehmend auf Figur 4 ist bei dem erfindungsgemäßen Verfahren außerdem vorgesehen, jeder Bitposition $k_2$ des zweiten Datenwortes $d_2$ ein individuelles Codewort $c_2$ zuzuordnen, das in einer zweiten Codierungstabelle 12 abgelegt ist. In dem Beispiel entsprechen die den einzelnen Bitpositionen $k_2$ des zweiten Datenwortes $d_2$ zugeordneten zweiten Codewörter den jeweiligen Bitpositionen des ersten Datenwortes $d_1$ zugeordneten ersten Codewörtern $c_1$. Selbstverständlich können die zweiten Codewörter $c_2$ der einzelnen Bitpositionen $k_2$ des zweiten Datenwortes $d_2$ jedoch völlig unabhängig von den ersten Codewörtern $c_1$ der Bitpositionen $k_1$ des ersten Datenwortes $d_1$ gewählt werden.

Das erfindungsgemäße Verfahren zur Codierung eines ersten und zweiten Datenwortes $d_1$, $d_2$ unter Verwendung der in den Figuren 3 und 4 dargestellten Codierungstabellen wird nachfolgend anhand von Figur 5 für ein erstes binäres Datenwort $d_1 = 0111100$ und ein zweites binäres Datenwort $d_2 = 0010011$ erläutert. In Dezimaldarstellung entspricht das erste Datenwort $d_1$ dem Wert 60 und das zweite Datenwort dem Wert 19.

Das Verfahren sieht vor, die durch die Datenworte repräsentierten Datenwerte zunächst durch Approximationswerte anzunähern. Hierzu werden in dem Beispiel zunächst die für den Wert der ersten und zweiten Datenworte $d_1$, $d_2$ am meisten relevanten Datenbits ermittelt.

In dem Beispiel, bei dem die Datenbits beginnend mit dem am wenigsten relevanten Datenbit (LSB) der Datenworte $d_1$, $d_2$ mit 1 bis 7 nummeriert sind und bei dem das am meisten relevante Datenbit (MSB) der Datenworte $d_1$, $d_2$ die Bitposition 7 besitzt, sind dies die Datenbits $k_1 = 6$ für das erste Datenwort $d_1$ und $k_2 = 5$ für das zweite Datenwort $d_2$. Die höherwertigen Datenbits dieser beiden Datenworte $d_1$, $d_2$ sind jeweils 0 und liefern somit keinen relevanten Anteil zu den Werten der beiden Datenworte $d_1 = 0111100_2 = 60_{10}$ und $d_2 = 0010011_2 = 19_{10}$.

Das Verfahren sieht weiterhin vor, die den Bitpositionen der höchsten relevanten Bitpositionen $k_1 = 6$ und $k_2 = 5$ zugeordneten Codewörter auf erste und zweite Datenabschnitte des codierten Datenwortes $d_3$ abzubilden. Das der Bitposition $k_1 = 6$ des ersten Datenwortes d1 zugeordnete erste Codewort c1(6) = 110 ist der ersten Codetabelle 11 zu entnehmen und wird in dem Beispiel auf den ersten Datenabschnitt des codierten Datenwortes d3 abgebildet, der die drei Bitpositionen k3 = 8 bis k3 = 10 des codierten Datenwortes d3 umfasst. Das der Bitposition k2 = 5 des zweiten Datenwortes d2 zugeordnete zweite Codewort c2(5) = 101 ist der zweiten Codetabelle 12 zu entnehmen und wird auf einen zweiten Datenabschnitt des codierten Datenwortes d3, der die Bitpositionen k3 = 5 bis k3 = 7 umfasst, abgebildet.

Die in dem codierten Datenwort enthaltene Information über die höchste relevanten Bitposition in dem ersten und zweiten Datenwort d1, d2 ermöglicht eine erste Approximation an die durch das erste und zweite Datenwort d1, d2 repräsentierten Datenwerte. Anhand der in dem ersten und zweiten Codewort c1(6), c2(5) enthaltende Information über das jeweils am meisten relevante Bit in dem ersten und zweiten Datenwort d1, d2 ist ersichtlich, dass das erste Datenwort d1 einen Wert größer oder gleich $2^5=32$ und dass des zweite Datenwort d2 einen Wert größer oder gleich $2^4=16$ besitzt.

Allgemein entsprechen die Approximationswerte für den ersten und zweiten Datenwert in dem dargestellten Beispiel einer Zweierpotenz der Bitpositionen der höchsten relevanten Datenbits, wenn die Nummerierung der Bitpositionen derart erfolgt, dass dem LSB jeweils die Bitposition 0 zugeordnet ist. Der erste Approximationswert für den ersten Datenwert beträgt in dem Beispiel $2^{k1-1}=2^5=32$ und der zweite Approximationswert für den zweiten Datenwert beträgt $2^{k2-1}=2^4=16$.

Für eine weitere Approximation an die zu übertragenden Datenwörter d1, d2 stehen zusätzliche Bitpositionen, in dem Beispiel die Bitpositionen k3=1 bis k3=4, des codierten Datenwortes d3 zur Verfügung, welche zur Übertragung von Informationsanteilen des ersten und zweiten Datenwortes genutzt werden, die weniger relevant sind als die in dem ersten und zweiten Datenwort c1(6), c2(5) enthaltene Information über die Position des jeweils relevantesten Datenbits. Jeder zusätzlich auf das kodierte Datenwort d3 abgebildete Informationsanteil, in dem Beispiel jedes zusätzliche Datenbit, des ersten und zweiten Datenwortes d1, d2 ermöglicht empfängerseitig eine genauere Approximation an das jeweilige Datenwort d1, d2 und reduziert den aus der Codierung resultierenden Fehler.

Die Abbildung weiterer Datenbits des ersten und zweiten Datenwortes auf das codierte Datenwort entspricht einer Codierung der Differenzen zwischen dem jeweiligen Datenwert und den durch das erste und zweite Codewort repräsentierten Approximationswerten.

In dem dargestellten Beispiel, bei dem sowohl die zu übertragenden Datenworte d1, d2 als auch das codierte Datenwort d3 jeweils binäre Datenworte sind, werden einzelne Datenbits der Datenworte d1, d2 nach einem vorgegebenen Schema unmittelbar auf die zusätzlichen Bitpositionen k3 bis k4 abgebildet.

Diese Abbildung erfolgt mit dem Ziel, den aufgrund der Datenreduktion von m1 + m2 = 14 Bit auf n = 10 Bit erzeugten Codierungsfehler möglichst gering zu halten. Jeder Bitposition des ersten und zweiten Datenwortes ist dabei eine Rangfolgenummer zugeordnet, die ein Maß dafür ist, wie groß ein maximaler Fehler wäre, wenn ausgehend von dieser jeweiligen Bitposition die Werte aller nächstkleineren Positionen nicht codiert würden. Im einfachsten Fall entsprechen diese Rangfolgenummern r1, r2 der Nummer der jeweiligen Bitpositionen. Die Rangfolgenummer einer gegebenen Bitposition ist dabei um so größer, je größer der Codierungsfehler wäre, wenn ausgehend von dieser vorgegebenen Bitposition alle kleineren Bitpositionen nicht codiert oder zu Null gesetzt würden. Würde von dem ersten Datenwort d1 nur die höchste relevante Bitposition k1 = 6 übertragen, was der oben erläuterten ersten Approximation an den Wert des ersten Datenwortes d1 entspricht, so würde bei Vernachlässigung oder zu Null setzen der Bitpositionen k1 = 5 bis k1 = 1 der maximale Codierungsfehler Emaxl = $11111_2 = 31_{10}$ betragen. Würde von dem zweiten Datenwort d2 in dem Beispiel nur die Bitposition des höchsten relevanten Bits k2 = 5 übertragen, was der oben erläuterten ersten Approximation an den Wert des zweiten Datenwortes d2 entspricht, so würde der maximale Fehler Emax2 = $1111_2 = 15_{10}$ betragen.

Für die Abbildung weiterer Datenbits des ersten und zweiten Datenwortes auf die zusätzlichen Bitpositionen des codierten Datenwortes d3 wird nun ermittelt, welches die höchste Bitposition des ersten und zweiten Datenwortes d1, d2 ist, deren Datenbit auf das codierte Datenwort d3 abgebildet ist. Zu Beginn des Verfahrens sind dies die Bitpositionen der höchsten relevanten Datenbits, nämlich die Bitposition k1 = 6 des ersten Datenwortes d1, dem die Rangfolgenummer r1 = 6 zugeordnet ist, und die Bitposition k2 = 5 des zweiten Datenwortes d2, der die Rangfolgenummer r2 = 5 zugeordnet ist.

Diese Rangfolgenummern r1 = 6 und r2 = 5 werden verglichen, um zu entscheiden, aus welchen der beiden Datenworte d1, d2 das erste zusätzliche Datenbit an der Bitposition k3 = 4 des codierten Datenwortes d3 stammen soll. Die Auswahl erfolgt in dem Beispiel derart, dass das Datenbit an der zusätzlichen Bitposition des codierten Datenwortes d3 aus dem der ersten und zweiten Datenworte d1, d2 ausgewählt wird, dessen höchste bereits auf das codierte Datenwort abgebildete Bitposition die größere Rangfolgenummer besitzt. Bei gleichen Rangfolgenummern der zuletzt codierten Bitpositionen wird in dem Beispiel jeweils das Datenbit der nächstkleineren Bitposition des ersten Datenwortes d1 auf das codierte Datenwort d3 abgebildet.

In dem konkreten Beispiel bedeutet dies, dass nach Codieren der Bitpositionen k1 = 6 und k2 = 5 mit den Rangfolgenummern r1 = 6 und r2 = 5 auf den ersten und zweiten Datenabschnitt auf die erste zusätzliche Bitposition k3 = 4 des codierten Datenwortes d3 das Datenbit d1(5) der Bitposition k1 = 5 des ersten Datenwortes d1 abgebildet wird. Nach diesem Schritt gilt für die Rangfolgenummer der höchsten bereits auf das codierte Datenwort d3 abgebildeten Bitposition des ersten Datenwortes d1 r1 = 5, während nach wie vor r2 = 5 gilt. Auf die zweite zusätzliche Bitposition k3 = 3 des codierten Datenwortes d3 wird als nächstes das Datenbit d1(4) der Bitposition k1 = 4 des ersten Datenwortes d1 abgebildet. Nach diesem Schritt gilt r1 = 4 und r2 = 5, so dass in einem nächsten Schritt das Datenbit d2(4) des zweiten Datenwortes d2 auf die dritte zusätzliche Bitposition k3 (=2) des codierten Datenwortes d3 abgebildet wird. Nach diesem Verfahrensschritt gilt r1 = 4 und r2 = 4, so dass im nächsten Verfahrensschritt ein Datenbit aus dem ersten Datenwort codiert wird, nämlich das Datenbit der nach der Bitposition k1=4 nächstrelevanten Bitposition k1=3, das Datenbit d1(3) .

Die verbliebenen Datenbits an den Bitpositionen k1 = 2 und k1 =1 des ersten Datenwortes d1 sowie die verbliebenen Datenbits der Bitpositionen k2 = 3 bis k2 = 1 des zweiten Datenwortes d2 werden bei der Codierung nicht mehr berücksichtigt, so dass der maximale Fehler bei der Codierung $emax1 = 11_2 = 3_{10}$ für das erste Datenwort d1 und $emax2 = 111_2 = 7_{10}$ für das zweite Datenwort d2 beträgt.

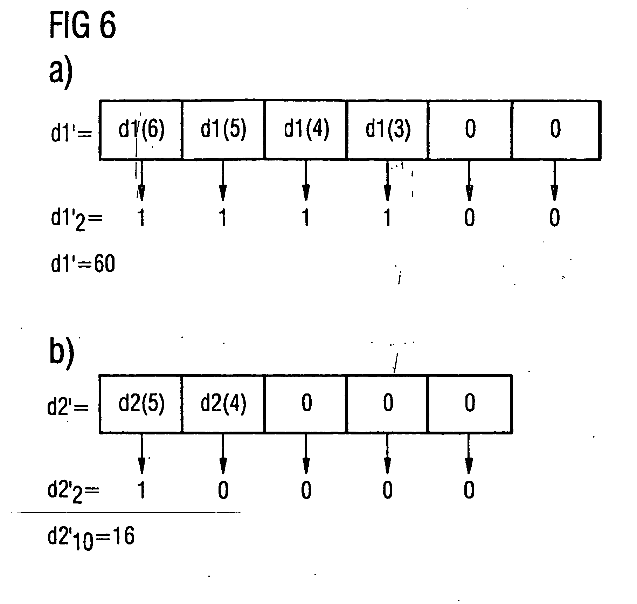

Bezugnehmend auf Figur 5 werden in dem Ausführungsbeispiel von dem ersten Datenwort d1 Datenbits d1(6), d1(5), d1(4) und d1(3) auf das codierte Datenwort d3 abgebildet und übertragen. Empfängerseitig ist aus diesen übertragenen Datenbits bezugnehmend auf Figur 6a ein gesendetes Datenbit $d1' = 111100_2 = 60_{10}$ rekonstruierbar. Dabei werden die Datenbits des ersten Datenwortes d1, zu denen keine Information übertragen wird, beispielsweise zu 0 gesetzt. In dem Beispiel gilt d1 = d1' = 60, so dass kein Codierungsfehler vorhanden ist, da zufälligerweise die beiden nicht übertragenen Datenbits d1(2), d1(1) des ersten Datenwortes d1 0 sind.

Von dem zweiten Datenwort d2 werden die Datenbits d2(5) und d2(4) übertragen, die nicht übertragenen Datenbits d2(3), d2(2) und d2(1) werden jeweils zu 0 gesetzt. Hieraus ist das Datenwort $d2' = 10000_2 = 16_{10}$ rekonstruierbar. Der Codierungsfehler beträgt hierbei d2 bis $d2' = 011_2 = 3_{10}$, da die bei der Rekonstruktion des Datenwortes zu 0 gesetzten Datenbits d2' (2) und d2' (1) ungleich der Datenbits d2(2), d2 (1) sind.

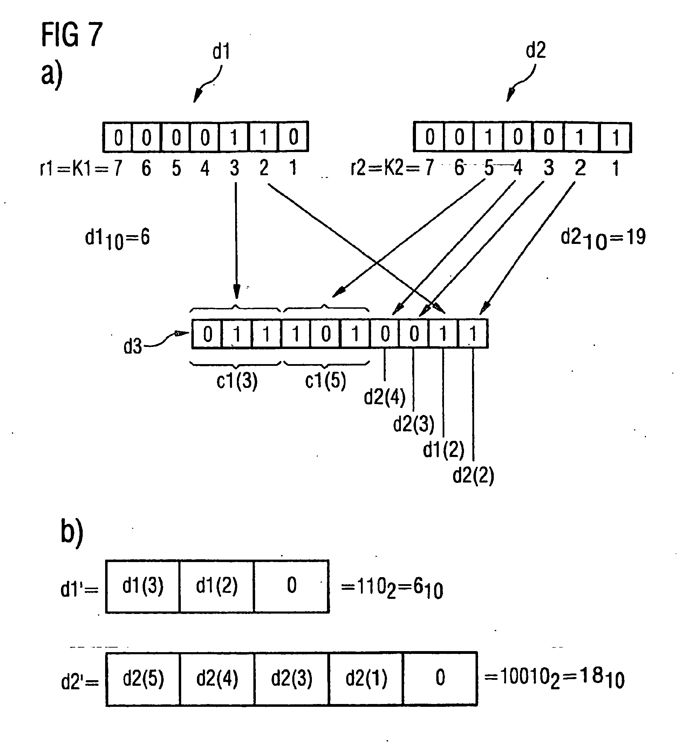

Figur 7a veranschaulicht das erfindungsgemäße Codierungsverfahren anhand eines weiteren Beispiels für die Übertragung eines ersten Datenwortes $d1 = 110_2 = 61_0$ und eines zweiten Datenwortes $d2 = 10011_2 = 19_{10}$ .

Das höchste relevante Datenbit des ersten Datenwortes d1 ist das Datenbit an der Bitposition k1 = 3, dem bezugnehmend auf die Tabelle in Figur 3 das erste Codewort cl(3) = 011 zugeordnet ist, und das auf einen ersten Datenabschnitt des codierten Datenwortes d3 abgebildet wird. Das höchste relevante Datenbit des zweiten Datenwortes d2 ist das Datenbit der Bitposition k2 = 5, dem bezugnehmend auf Figur 4 das zweite Codewort c1 (5) = 101 zugewiesen ist, welches auf den zweiten Datenabschnitt des codierten Datenwortes d3 abgebildet wird.

Nach diesen ersten Verfahrensschritten stehen sich die Rangfolgenummer r1 = 3 für die Bitposition das höchsten relevante Datenbit des ersten Datenwortes d1 und r2 = 5 des höchsten relevanten Datenbits des zweiten Datenwortes d2 gegenüber. In einem nächsten Verfahrensschritt wird das Datenbit der Bitposition k2 = 4 des zweiten Datenwortes d2 auf die erste zusätzliche Bitposition des dritten Datenwortes d3 abgebildet. Da die Rangfolgenummer r1 = 4 dieses zuletzt aus dem zweiten Datenwort d2 abgebildeten Datenbits d2(4) immer noch größer ist, als die Rangfolgenummer der höchsten bereits auf das codierte Datenwort abgebildeten Bitposition des ersten Datenwortes, wird in einem nächsten Verfahrensschritt erneut ein Datenbit des zweiten Datenwortes codiert, nämlich das Datenbit d2(3) der Bitposition k2=3 des zweiten Datenbits d2. Danach gilt r1 = 3 für die Rangfolgenummer der höchsten aus dem ersten Datenwort d1 bereits codierten Bitposition und r2 = 3 für die Rangfolgenummer der höchsten bereits aus dem zweiten Datenwort d2 codierten Bitposition, so dass die Rangfolgenummern der zuletzt aus den jeweiligen Datenworten d1, d2 auf das codierte Datenwort d3 abgebildeten Datenbits übereiristimmen. In einem nächsten Verfahrensschritt wird daher das Datenbit d1(2) der Position k1=2 des ersten Datenwortes d1 auf den dritten zusätzlichen Datenabschnitt des codierten Datenwortes d3 abgebildet. Auf den vierten zusätzlichen Datenabschnitt an der Bitposition k3 = 1 des codierten Datenwortes d3 wird in einem letzten Verfahrensschritt das Datenbit d2(2) der Bitposition k2 = 2 des zweiten Datenwortes d2 abgebildet.

Bei diesem konkreten Zahlenbeispiel werden von dem ersten Datenwort d1 die Datenbits d1(3) und d1(2) codiert, so dass für das aus dem codierten Datenwort rekonstruierte Datenwort nach der Übertragung gemäß Figur 7b $d1' = 110_2 = 6_{10}$ gilt. Von dem zweiten Datenwort d2 werden bei diesem Beispiel die vier Datenbits d2(5) bis d2(1) - im Gegensatz zu den nur drei Datenbits bei dem Beispiel gemäß Figur 5 und 6 - übertragen, wobei für das rekonstruierte Datenwort $d2' = 10010_2 = 18_{10}$ gilt. Der Codierungsfehler beträgt in diesem Fall nur noch 1.

Wie anhand der konkreten Zahlenbeispiele in den Figuren 5 bis 7 deutlich wird, verwendet das erfindungsgemäße Codierungsverfahren keine starre Zuordnung einzelner Bitpositionen des codierten Datenwortes zu einzelnen Bitpositionen der beiden zu übertragenen Datenwörter d1, d2, sondern diese Bitpositionen werden adaptiv unter anderem abhängig von den konkreten zu übertragenen Werten zugewiesen, stets mit dem Ziel, den maximalen Codierungsfehler möglichst gering zu halten.

Bisher noch nicht berücksichtigt wurde der Fall, bei dem eines der beiden Datenworte oder beide Datenworte 0 sind. In diesem Fall, bei dem es keine höchste relevante Position gibt, wird auf den ersten bzw. zweiten Datenabschnitt des codierten Datenwortes ein spezielles erstes bzw. zweites Codewort abgebildet, das diesen Fall berücksichtigt. Dieses Codewort ist bezugnehmend auf die Figuren 3 und 4 mit c1(0) bzw. c2(0) bezeichnet und hat beispielsweise den Wert $000_2$. Diesem Codewort ist beispielsweise die Rangfolgenummer 0 zugeordnet, mit dem Effekt, dass auf die zusätzlichen Datenabschnitte des codierten Datenwortes nur Datenbits des jeweils anderen Datenwortes abgebildet werden. Sind beide Datenworte gleich 0, so wird beispielsweise ein codiertes Datenwort d3 übertragen, das ebenfalls nur Nullen umfasst.

Wird beim Abbilden der Datenbits des ersten und zweiten Datenwortes d1, d2 auf das codierte Datenwort der Fall erreicht, dass die LSB-Bits der beiden Datenworte d1, d2 bereits auf das codierte Datenwort d3 abgebildet sind, so werden gegebenenfalls noch zur Verfügung stehende Datenabschnitte des codierten Datenwortes beispielsweise mit Nullen aufgefüllt.

In nicht näher dargestellter Weise besteht bei dem anhand der Figuren 2 bis 7 erläuterten Verfahren selbstverständlich auch die Möglichkeit, vorzeichenbehaftete Datenwörter, d.h. Datenwörter, die einen Betrag und ein Vorzeichen enthalten, zu übertragen. Hierbei sind in dem codierten Datenwort neben den Datenbits für den Betrag zusätzliche Bits vorzusehen, auf welche dann jeweils die Vorzeichenbits der ersten und zweiten Datenworte abgebildet werden.

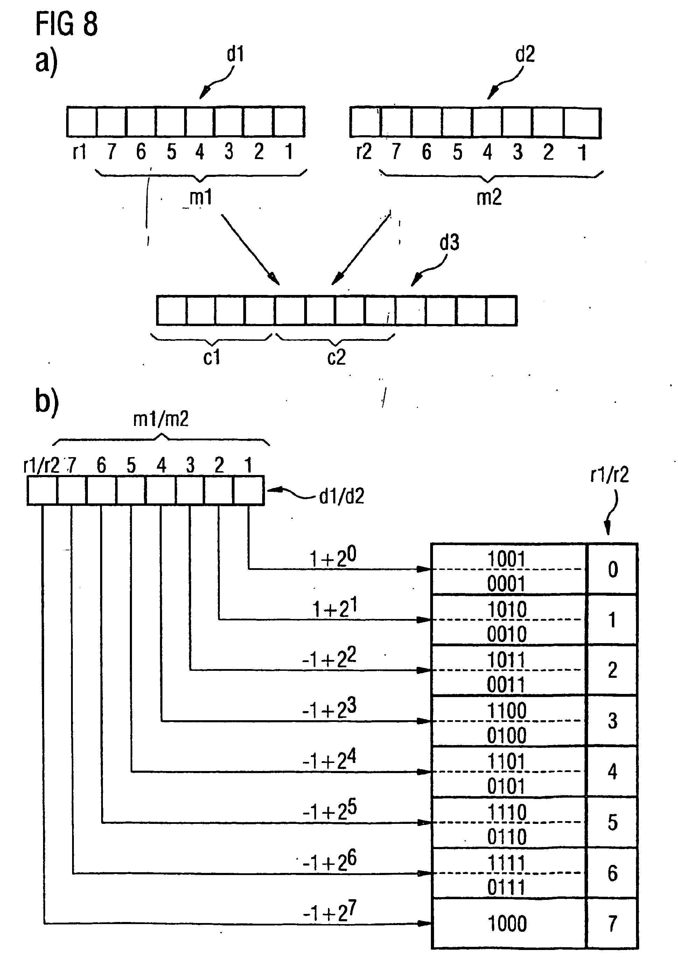

Darüber hinaus besteht jedoch auch die Möglichkeit, das Vorzeichen in den den einzelnen Bitpositionen zugeordneten ersten bzw. zweiten Codewörtern c1, c2 des ersten und zweiten Datenwortes d1, d2 zu berücksichtigen, wie nachfolgend anhand von Figur 8 erläutert ist.

Figur 8a veranschaulicht ein erstes Datenwort d1 mit einer Wortlänge von 8 Bit, das ein Vorzeichenbit v1 und m1 = 7 Datenbit umfasst. Dargestellt ist außerdem ein zweites Datenwort d2 mit einer Länge 8 Bit, das ein Vorzeichenbit v2 und m2 =7 Datenbit umfasst. Diese beiden Datenworte d1, d2 sollen gemäß dem erfindungsgemäßen Verfahren auf ein codiertes Datenwort d3 der Wortlänge 12 Bit abgebildet werden.

Bezugnehmend auf Figur 8b ist hierbei vorgesehen, jeder Bitposition der ersten und zweiten Datenworte d1, d2 zwei Codewörter zuzuordnen, also jeder Bitposition des ersten Datenwortes d1 zwei erste Codewörter zuzuordnen und jeder Bitposition des zweiten Datenwortes d2 zwei zweite Codewörter zuzuordnen. Ohne Beschränkung der Allgemeinheit ist in dem Ausführungsbeispiel gemäß Figur 8b davon ausgegangen, dass entsprechenden Bitpositionen des ersten und zweiten Datenwortes jeweils gleiche Codewörter zugeordnet sind.

Die einer Bitposition zugeordneten Codeworte, beispielsweise die Codeworte 1001 und 0001, die der ersten Bitposition zugeordnet sind, unterscheiden sich dabei in wenigstens einer Bitposition, wobei eines der Codeworte für die jeweilige Bitposition und ein positives Vorzeichen des jeweiligen Datenwortes steht und das andere der einer Bitposition zugeordneten Codewörter für die jeweilige Bitposition und ein negatives Vorzeichen des jeweiligen Datenwortes steht. In dem Beispiel gemäß Figur 8b unterscheiden sich die einer Bitposition zugeordneten Codewörter an genau einer Bitposition, in dem Beispiel der MSB-Position der Codewörter. Selbstverständlich können sich die einer Bitposition zugeordneten Codeworte allerdings beliebig unterscheiden. Wesentlich ist, dass wie bei jedem Codierungsverfahren die Codierungsvorschrift, also die den einzelnen Bitpositionen zugeordneten Codeworte empfängerseitig bekannt sind.

Die Tabelle in Figur 8b zeigt neben den Codeworten, die einzelnen Bitpositionen zugeordnet sind, auch die jeweiligen Rangfolgenummern, die in dem Beispiel der Bitposition vermindert um 1 entsprechen.

Von den mit 4 Bit darstellbaren $2^4$=16 Codeworten sind in der Tabelle gemäß Figur 8b 14 verwendet, um die 7 Bitpositionen und jeweils zwei unterschiedliche Vorzeichen des Datenwortes berücksichtigen zu können. Nicht verwendet für die Bitpositionen sind in dem Beispiel die Codeworte 0000 und 1000. Das Codewort 0000 wird dabei beispielsweise verwendet, um ein Datenwort zu codieren, das an seinen sieben Datenbitpositionen und gegebenenfalls an seiner Vorzeichenbitposition nur Nullen umfasst.

Allgemein gilt, dass sich mit einem Codewort der Länge k das Vorzeichen eines Datenwortes und eine von i=$2^k$-1 Positionen des höchsten nicht relevanten Datenbits übertragen lässt. Das Codewort eignet sich somit für die Codierung des Vorzeichens und der Position des höchsten relevanten Datenbits für Datenwerte zwischen $-(2^i-1)...2^i-1$.

Durch ein sieben Datenbits und ein Vorzeichenbit umfassendes Datenwort d1, d2 können dezimale Datenwerte zwischen -127 und +127 dargestellt werden. Um die Position des höchsten relevanten Datenbits der sieben Datenbits und die Vorzeicheninformation zu übertragen sind entsprechend Codewörter mit vier Codebits, ein Codebit für das Vorzeichen und drei Codebits für die Position des höchsten relevanten Datenbits, erforderlich.

Um für Datenwerte zwischen -255 und +255 die Position des höchsten relevanten Datenbits und das Vorzeichen zu übertragen sind Codewörter fünf Codebits, nämlich einem Codebit für das Vorzeichen und vier Codebits für die Position des höchsten relevanten Datenbits, erforderlich.

Bei einer Ausführungsform der Erfindung ist vorgesehen, Datenwerte, deren Betrag oberhalb eines vorgegebenen Wertes liegt, ohne Vorzeicheninformation zu codieren, d.h. auf das codierte Datenwort abzubilden. Dieses Vorgehen eignet sich dann, wenn als Datenwerte Differenzwerte zwischen zwei aufeinanderfolgenden Datenwerten einer Datenfolge zu übertragen sind, da für Differenzwerte, die oberhalb eines vorgegebenen Wertes liegen, die Vorzeicheninformation anhand zuvor übertragener Daten rekonstruiert werden kann, wie nachfolgend noch erläutert werden wird.

Bei dem anhand von Figur 8 erläuterten Beispiel, bei dem Codewörter mit 4 Codebits zur Verfügung stehen, ist vorgesehen, Differenzwerte mit Beträgen größer oder gleich 128 (=$2^7$) ohne Vorzeichen zu übertragen. Das Codewort 1000 wird in dem Beispiel dazu verwendet, um die Information zu übertragen, dass der zu übertragende Differenzwert betragsmäßig größer oder gleich 128 ist, d.h. in einem Intervall [128,255] liegt. Die Übertragung des Codewortes entspricht einer Übertragung eines vorzeichenunabhängigen Approximationswertes von 128. Um zusätzlich eine Vorzeicheninformation zu übertragen wäre ein zusätzliches Bit des Codewortes erforderlich, das aus den im folgenden dargelegten Gründen jedoch gespart werden kann.

Wird bei dieser Ausgestaltung des Verfahrens empfängerseitig die Übertragung eines Differenz-Amplitudenwertes größer oder gleich 128 für eines der ersten und zweiten Datenworte erkannt, so kann die Vorzeicheninformation anhand der bereits zuvor übertragenen Information ermittelt werden.

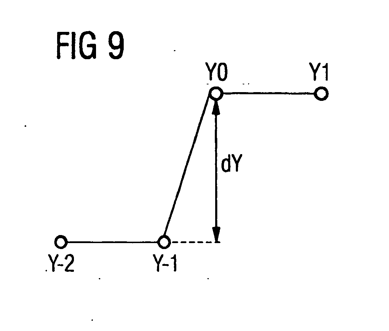

Es wird davon ausgegangen, dass die mittels des erfindungsgemäßen Verfahrens übertragenen Datenwerte, die zwischen -255 und +255 liegen können, Differenzen zwischen jeweils zwei aufeinanderfolgenden Datenwerten einer Datenwertfolge repräsentieren, wobei Absolutwerte dieser Datenwerte zwischen O und 255 liegen. Zur Verdeutlichung ist in Figur 9 schematisch eine solche Datenfolge mit Datenwerten Y-2...Y1 dargestellt. Ein Differenzwert zwischen einem Datenwert Y0 und einem vorherigen Datenwert Y-1 ist in Figur 9 mit dY bezeichnet.

Um einen Sprung vom Wert 0 des ersten Wertes Y-1 auf einen Wert 255 des nachfolgenden Wertes Y0 zu übertragen muss ein Differenzwert +255 codiert und übertragen werden, während für einen Sprung von 255 auf 0 ein Differenzwert -255 zu codieren und übertragen ist. Die Absolutwerte der Werte der Datenfolge werden empfängerseitig rekonstruiert, indem ein empfangener Differenzwert zu dem unmittelbar zuvor ermittelten Absolutwert addiert wird. Zur Rekonstruktion des Datenwertes Y0 wird somit die Summe aus dem Wert Y-1 und dem Differenzwert dY gebildet.

Wird bei dem erfindungsgemäßen Verfahren ein vorzeichenunabhängiger Differenzwert dY größer oder gleich 128 empfangen, so wird ermittelt, welchen Wert der vorangehende Absolutwert Y-1 der Datenfolge hat. Liegt dieser Wert im Intervall [0, 128[ so wird der aktuell empfangene Differenzwert dY als positiver Differenzwert angenommen, da ein negativer Differenzwert dY mit einem Betrag größer oder gleich 128 bei Addition zu dem vorherigen Absolutwert Y-1 des Intervalls [0, 128[ zu einem ungültigen aktuellen Datenwert Y0 Wert kleiner Null führen würde. Liegt der vorherige Wert Y-1 hingegen in dem Intervall [128,255] und wird ein Differenzwert größer oder gleich 128 empfangen, so wird der Differenzwert als negativer Differenzwert angenommen, da ein positiver Differenzwert dY mit einem Betrag größer oder gleich 128 bei Addition zu dem vorherigen Absolutwert Y-1 des Intervalls [128,255] zu einem ungültigen aktuellen Datenwert Y0 Wert größer 255 führen würde.

Zusammenfassend können Differenzwerte mit einem Betrag größer als 128 ohne Vorzeichen übertragen werden, da die Vorzeicheninformation empfängerseitig anhand des jeweils vorhergehenden Wertes der Datenfolge rekonstruiert werden kann. Differenzwerte mit einem Betrag größer als 128 werden somit ohne Vorzeicheninformation übertragen.

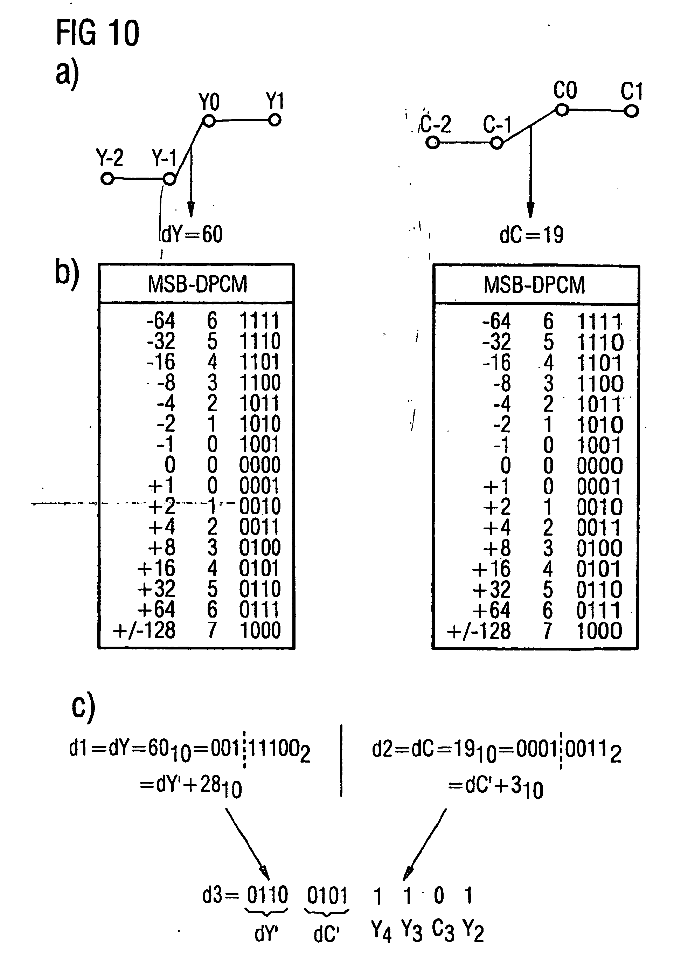

Ein Kodierungsverfahren unter Verwendung einer anhand von Figur 8b erläuterten Codierungstabelle wird zusammenfassend anhand von Figur 10 für die Kodierung zweier Differenzwerte dY, dC erläutert. Diese Differenzwerte dY, dC repräsentieren jeweils eine Differenz zwischen einem aktuellen Datenwert und einem vorangehenden Datenwert zweier Datenfolgen Y-2...Y1 bzw. C-2...C1. Als Zahlenbeispiele sind in Figur 10 $dY=60_{10}=00111100_2$ und $dC=19_{10}=00010011_2$ gewählt.

In einem ersten Verfahrensschritt erfolgt eine erste Approximation an den zu kodierenden Differenzwert dY, dC unter Verwendung der Codierungstabelle, in der Approximationswerte für die zu übertragenen Differenzwerte abgelegt sind. Jedem Approximationswert ist dabei ein Codewort, in dem Beispiel ein Codewort der Länge 4 Bit, abgelegt. Die Approximationswerte sind bei den in Figur 10b dargestellten Codierungstabellen so gewählt, dass sie jeweils Zweierpotenzen sind. Anhand der Codierungstabelle wird dabei der Approximationswert ausgewählt, der dem zu übertragenen Datenwert am nächsten kommt, der betragsmäßig jedoch kleiner als der zu übertragene Datenwert ist. In dem dargestellten Beispiel wird für den zu übertragenden Datenwert dY=60 aus der Codierungstabelle der erste Approximationswert dY'=32 ausgewählt, dem das Codewort 0110 zugeordnet ist. Für den zu übertragenden Datenwert dC=19 wird als erster Approximationswert aus der Codierungstabelle dC'=16 ausgewählt, dem das Codewort 0101 zugeordnet ist. In dem Beispiel werden Approximationswerte mit Beträgen zwischen 1 und 64 nach Vorzeichen unterschieden, während für zu übertragende Differenzwerte mit Werten größer gleich 128 der erste Approximationswert vorzeichenunabhängig codiert und übertragen wird.

Die den ersten Approximationswerten dY' und dC' zugeordneten Codeworte werden anschließend auf das codierte Datenwort d3 abgebildet. Die übrigen Datenbits des codierten Datenwortes d3, in dem dargestellten Beispiel vier Datenbits, werden dazu genutzt, die Differenz zwischen dem zu übertragenden Datenwert und dem ersten Approximationswert möglichst exakt darzustellen und zu übertragen. Für den Datenwert dY=60 und dessen ersten Approximationswert dY'=32 beträgt diese Differenz $28_{10}=11100_2$, und für den Datenwert dC=19 und dessen ersten Approximationswert dC'=16 beträgt diese Differenz $3_{10}=0011_2$.

Die Codierung dieser Differenzen, d.h. die Abbildung der Datenbits dieser Differenzen auf die zusätzlichen Datenbits des codierten Datenwortes d3 erfolgt in dem Beispiel mit dem Ziel, den absoluten Fehler für die Übertragung jedes Datenwortes möglichst zu minimieren. Dies erfolgt in dem Beispiel dadurch, dass Datenbits der binären Datenworte $11100_2$ bzw. $0011_2$, die die Differenzwerte repräsentieren, auf die zur Verfügung stehenden zusätzlichen Bits des codierten Datenwortes d3 abgebildet werden. Die Abbildung erfolgt dabei mit dem Ziel, für beide Datenwerte dY, dC jeweils einen gleich großen maximalen Codierungsfehler zu erhalten. In dem Beispiel werden hierfür die höchsten Datenbits $Y_4$, $Y_3$, $Y_2$ des ersten Differenzwertes und das Datenbit $C_3$ des zweiten Differenzwertes auf das codierte Datenwort abgebildet. Nicht berücksichtigt von dem ersten Differenzwert werden dabei die Datenbits $Y_1$ und $Y_0$ des ersten Differenzwertes und die Datenbits $C_2$, $C_1$ und $C_0$ des zweiten Differenzwertes, woraus für das erste Datenwort ein maximaler Codierungsfehler von $11_2 = 3_{10}$ und für den zweiten Datenwert dC ein maximaler Codierungsfehler von $111_2 = 8_{10}$ resultiert.

Zusammenfassend erfolgt bei dem erfindungsgemäßen Übertragungsverfahren zunächst eine erste Approximation an den zu übertragenden Datenwert dY, dC, wobei der Approximationswert, gegebenenfalls einschließlich einer Vorzeicheninformation, durch ein in einer Codierungstabelle abgelegtes Codewort codiert wird. Eine weitere sukzessive Approximation an die zu übertragenden Datenwerte dY, dC erfolgt durch wenigstens teilweise Codierung der verbleibenden Differenzen, wobei der Codierungsfehler um so größer ist, je mehr Datenbits des Differenzwertes nicht auf das codierte Datenwort abgebildet werden können.

Wenngleich das erfindungsgemäße Verfahren zuvor für die Abbildung eines ersten und zweiten Datenwortes auf ein codiertes Datenwort erläutert wurde, sei darauf hingewiesen, dass das erfindungsgemäße Verfahren selbstverständlich auch dazu geeignet ist, mehr als zwei Datenworte auf ein codiertes Datenwort abzubilden.

Bei den bislang erläuterten Verfahren umfasst das codierte Datenwort c3 jeweils eine vorgegebene Länge. Der mögliche Codierungsfehler, der sich bei der Codierung zweier Datenworte auf das codierte Datenwort ergibt, ist dabei insbesondere abhängig von dem Wert des ersten und zweiten Datenwortes und nimmt in den zuvor erläuterten Beispielen mit zunehmender Amplitude des durch das jeweilige Datenwort repräsentierten Wertes zu.

Zur Reduzierung des Codierungsfehlers ist bei einer weiteren Ausführungsform vorgesehen, die Länge des codierten Datenwortes variabel zu gestalten, indem die Anzahl der zusätzlich zur Verfügung stehenden Datenabschnitte variieren kann. So besteht die Möglichkeit, so viele zusätzliche Datenabschnitte in dem codierten Datenwort vorzusehen, dass vorgegebene Datenbits des ersten Datenwortes d1 und des zweiten Datenwortes sicher codiert werden. Dies sei nachfolgend anhand von Figur 5 erläutert.

Wie erläutert beträgt der maximale Codierungsfehler des ersten Datenwortes d1 bei dem anhand von Figur 5 erläuterten Verfahren $11_2 = 3_{10}$, während der maximale Fehler des zweiten Datenwortes d2 $111_2 = 7_{10}$ beträgt. Mit dem Ziel, den Codierungsfehler für beide Datenworte d1, d2 sicher nicht größer als $11_2 = 3_{10}$ werden zu lassen ist bei einer Ausführungsform des Verfahrens deshalb vorgesehen, die Abbildung von Datenbits dieser Datenwörter so lange fortzusetzen, bis von beiden Datenwörtern sicher das Datenbit an der Position k1=3 und k2=3 codiert ist. Um dies für das Zahlenbeispiel in Figur 5 zu erreichen ist noch ein zusätzlicher Codierungsschritt erforderlich, bei dem das Datenbit d2(3) des zweiten Datenwortes d2 auf das codierte Datenwort abgebildet wird, was gestrichelt in Figur 5 dargestellt ist. Das in diesem Fall übertragene Datenwort besitzt in dem Beispiel dann eine Länge von 11 Bit.

Eine "verlustlose Kodierung" kann mittels dieses Verfahrens dann erreicht werden, wenn die Abbildung der Datenbits der Datenworte d1, d2 auf das codierte Datenwort d3 so lange fortgesetzt wird, bis von beiden Datenwörtern des am wenigstens relevante Bit (LSB), nämlich das Bit dl(1) und das Bit d2(1) auf das kodierte Datenwort abgebildet ist.

Selbstverständlich können die maximal erlaubten Codierungsfehler für das erste und zweite Datenwort d1, d2 auch unterschiedlich gewählt sein.

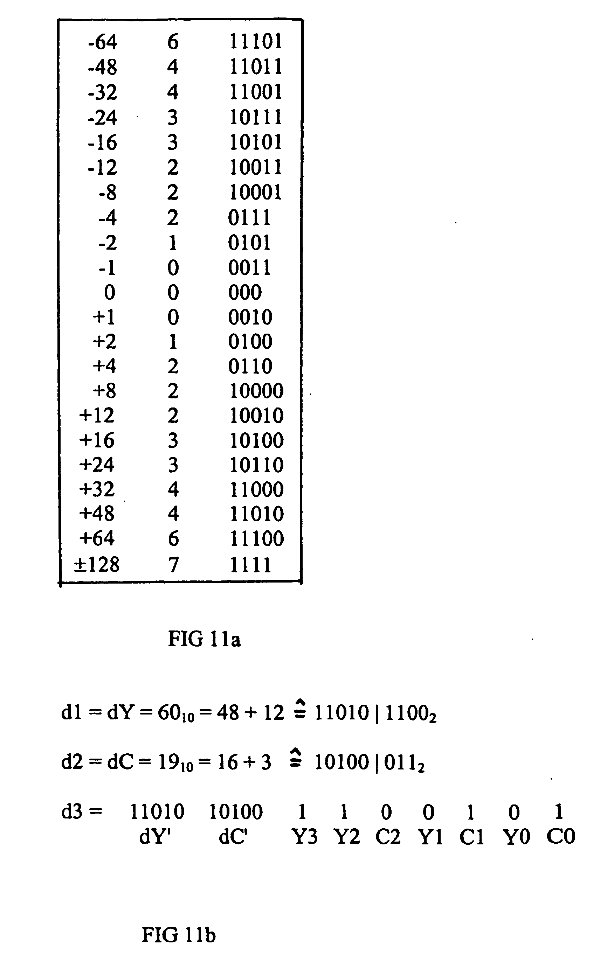

Bei den zuvor erläuterten Ausführungsbeispielen sind die Approximationswerte jeweils so gewählt, dass sie eine Zweierpotenz der Bitposition des höchsten relevanten Datenbits sind, es gilt also, dC' = $2^{MSB}$ bzw. dY' = $2^{MSB}$. MSB bezeichnet dabei die Bitposition des jeweiligen höchsten relevanten Datenbits, unter der Annahme, dass für das niedrigste relevante Datenbit (LSB) MSB=0 gilt. Die Erfindung ist allerdings nicht auf Potenzen der Zahl 2 als Approximationswerte beschränkt, sondern es können nahezu beliebige Approximationswerte vorgesehen werden, wie nachfolgend unter Bezugnahme auf Figur 11 erläutert wird.

Figur 11a zeigt eine Codierungstabelle, die in der linken Spalte Approximationswerte, in der mittleren Spalte Rangfolgenummern der einzelnen Approximationswerte und in der rechten Spalte die den einzelnen Approximationswerten zugeordneten Codewörter umfasst. Die in dieser Tabelle enthaltenen Approximationswerte unterscheiden sich von den in der Tabelle in Figur 10b angegebenen Approximationswerten dadurch, dass Approximationswerte, wie $\pm 12$, $\pm 24$, $\pm 48$ vorhanden sind, die keine ganzzahligen Potenzen der Zahl 2 sind. Vorzugsweise sind die einzelnen Approximationswerte so gewählt, dass die Differenzen zwischen einem Approximationswert und dem nächstgrößeren bzw. nächstkleineren Approximationswert jeweils ganzzahlige Potenzen der Zahl 2 sind. So gilt beispielsweise für die Differenz zwischen dem Approximationswert 32 und dem nächstgrößeren Approximationswert 48: 48-32 = 16 = $2^4$. Dieses Vorgehen, die Differenzen zwischen den einzelnen Approximationswerten als ganzzahlige Potenzen der Zahl 2 zu wählen, ist sinnvoll im Hinblick auf eine effektive Codierung ist allerdings im Hinblick auf die Funktionsfähigkeit des Codierungsverfahrens nicht erforderlich. Ebenfalls nicht erforderlich im Hinblick auf die Funktionsfähigkeit des Verfahrens ist, dass Approximationswerte in der Tabelle vorhanden sind, die ganzzahlige Potenzen der Zahl 2 sind.

Die Durchführung des erfindungsgemäßen Verfahrens unter Verwendung der in Figur 11a dargestellten Tabelle wird nachfolgend für eine Codierung der Datenwerte dY=60 und dC=19 erläutert:

Für jeden der zu codierenden Datenwerte dY, dC wird anhand der Tabelle zunächst der Approximationswert ermittelt, der dem jeweiligen Datenwert entspricht oder der betragsmäßig kleiner als der jeweilige Datenwert ist und der sich im Vergleich zu den übrigen Approximationswerten betragsmäßig am wenigsten von dem jeweiligen Datenwert unterscheidet. Für den Datenwert dY=60 führt dieses Vorgehen zu einem ersten Approximationswert 48, dem das Codewort dY' = 11010 zugeordnet ist. Für eine erste Differenz zwischen dem ersten Datenwert und dem ersten Approximationswert gilt hierbei: 60-48 = 12 = $1100_2$. Die binäre Darstellung 1100 dieser Differenz wird nachfolgend als erstes Differenz-Datenwort bezeichnet.

Für den Datenwert dC=19 ergibt sich ein zweiter Approximationswert 16, dem das Codewort dC' = 10100 zugeordnet ist. Für die Differenz zwischen dem zweiten Datenwert dC und dem ersten Approximationswert gilt hierbei: 19-16 = 3 = $011_2$. Die binäre Darstellung 011 dieser Differenz wird nachfolgend als zweites Differenz-Datenwort bezeichnet.

Jedem der Approximationswerte der Codierungstabelle ist eine Rangfolgenummer zugeordnet. Diese Rangfolgenummern sind in dem Beispiel jeweils eine ganze Zahl und sind davon abhängig, wie groß ein Fehler maximal ist, der bei Approximation eines Datenwertes durch einen Approximationswert auftreten kann. Dieser maximale Fehler entspricht dabei dem Betrag der Differenz zwischen dem jeweiligen Approximationswert und dem nächstgrößeren Approximationswert minus Eins. Für den ersten Approximationswert 48, dessen nächstgrößerer Approximationswert der Approximationswert 64 ist, beträgt dieser maximale Fehler 15 (=64-48-1). Für den zweiten Approximationswert 16, dessen nächstgrößerer Approximationswert in der Tabelle der Approximationswert 24 ist, beträgt dieser maximale Fehler 7 (=24-16-1). Dieser Fehler wird nachfolgend als der einem Approximationswert zugeordnete maximale Fehler bezeichnet.

Die Rangfolgenummer zu einem Approximationswert kann dabei diesem maximalen Fehler entsprechen. Vorzugsweise ist die Rangfolgenummer jedoch abhängig davon, auf welche Weise die Differenz zwischen dem ermittelten Approximationswert und dem Datenwert auf das codierte Datenwort abgebildet wird.

Bei einer Ausführungsform ist vorgesehen, die Differenz zwischen dem Approximationswert und dem Datenwert in der oben bereits erläuterten Weise als binäres Datenwort darzustellen und einzelne Datenbits dieses Datenwortes jeweils beginnend mit dem Datenbit der höchsten relevanten Bitposition und unter Berücksichtigung noch zu erläuternder Bedingungen auf das codierte Datenwort abzubilden. Die Rangfolgenummer eines Approximationswertes entspricht dabei der Anzahl der Bitpositionen, die erforderlich sind, um den dem Approximationswert zugeordneten maximalen Fehler binär darstellen zu können. Für den ersten Approximationswert 48 mit dem ihm zugeordneten maximalen Fehler 15 erhält man die Rangfolgenummer 4 und für den zweiten Approximationswert 16 mit dem ihm zugeordneten maximalen Fehler 7 erhält man die Rangfolgenummer 3. Allgemein lässt sich die Rangfolgenummer r darstellen als:

$$r = rd(ld(Emax)) \qquad (1)$$

ld(.) bezeichnet dabei die Funktion des Logarithmus zur Basis 2, Emax bezeichnet den einem Approximationswert zugeordneten maximalen Fehler und rd(.) bezeichnet eine Rundungsfunktion, die einen Zahlenwert jeweils auf den nächstgrößeren ganzzahligen Zahlenwert aufrundet, d.h. ein ganzzahliger Zahlenwert wird um Eins erhöht und ein nicht-ganzzahliger Wert wird auf den jeweils nächstgrößeren ganzzahligen Zahlenwert aufgerundet.

In dem Beispiel sind die Approximationswerte so gewählt, dass die Differenzen zwischen mehreren benachbarten Approximationswerten jeweils gleich groß sind, so dass einigen Approximationswerten gleiche Rangfolgenummern r zugeordnet sind. Die Rangfolgenummer 7 des Approximationswertes ±128 ergibt sich aus dem Betrag der Differenz (127) zu dem betragsmäßig jeweils größtmöglichen Datenwert ±255, zu deren Darstellung 7 Bitpositionen erforderlich sind.

Vorzugsweise wird die Tabelle der Approximationswerte abhängig von einer Signalstatistik der zu übertragenden Datenwerte erzeugt, indem für Wertebereiche, in denen die zu übertragenden Datenwerte besonders häufig liegen, mehr Approximationswerte oder Approximationswerte mit geringeren Abständen zu benachbarten Approximationswerten erzeugt werden, als für andere Wertebereiche.

Für eine Codierung vorzeichenbehafteter Werte werden die Approximationswerte bezugnehmend auf Figur 11a vorzugsweise "symmetrisch" zu Null gewählt, so dass zu jedem positiven Approximationswert ein negativer Approximationswert gleichen Betrags vorhanden ist.

Die dem ersten Approximationswert und dem wenigstens einen zweiten Approximationswert zugeordneten Codeworte werden bei dem Verfahren auf das codierte Datenwort abgebildet. Anschließend werden unter Berücksichtigung der Rangfolgenummern der Approximationswerte die Differenzen zwischen dem jeweiligen Datenwert und dem für den jeweiligen Datenwert ermittelten Approximationswert codiert. Dies kann dadurch erfolgen, dass diese Differenzen als binäre Datenworte dargestellt werden, und dass einzelne Datenbits dieser Datenworte auf das codierte Datenwort abgebildet werden. Die Anzahl der Bitpositionen eines solchen Differenz-Datenwortes, das eine Differenz zwischen einem Datenwert und einem Approximationswert repräsentiert, entspricht dabei der Anzahl der Bitpositionen die erforderlich sind, um den dem Approximationswert zugeordneten maximalen Fehler binär darstellen zu können. Bei einer Ermittlung der Rangfolgenummer gemäß Gleichung (1) entspricht die Anzahl der Bitpositionen eines Datenwortes, das eine Differenz zwischen einem Datenwert und einem Approximationswert repräsentiert, der Rangfolgenummer des Approximationswertes.

Den Differenz-Datenworten, die jeweils eine Differenz zwischen einem Datenwert und einem Approximationswert repräsentieren, wird zunächst die Rangfolgenummer des zugehörigen Approximationswertes zugewiesen. Die Abbildung der Datenbits dieser Differenz-Datenworte erfolgt dann abhängig von der Rangfolgenummer. So wird zunächst das höchste relevante Datenbit des Differenz-Datenwortes, dessen Approximationswert die höchste Rangfolgenummer besitzt auf das codierte Datenwort abgebildet. Die Rangfolgenummer, des Differenz-Datenwortes dessen Datenbit abgebildet wurde, wird dann um einen vorgegebenen Wert, vorzugsweise 1, verringert. Für den Fall gleicher Rangfolgenummern wird im Voraus festgelegt, welches Differenz-Datenwort zu bevorzugen ist, d.h. von welchem Differenz-Datenwort ein Datenbit auf das codierte Datenwort abgebildet.

Für die Abbildung eines nächsten Datenbits werden erneut die Rangfolgenummern der Differenz-Datenworte ermittelt und das höchste relevante Datenbit des Differenz-Datenwortes mit der höchsten Rangfolgenummer wird auf das codierte Datenwort abgebildet.

Bezogen auf eine Codierung der Werte dY=60 und dC=19 unter Verwendung der Code-Tabelle in Figur 11a bedeutet dies, dass aufgrund der größeren Rangfolgenummer des ersten Approximationswertes dY' zunächst das höchste relevante Datenbit $Y_3=1$ des ersten Differenzwertes bzw. ersten Differenz-Datenwortes $1100_2$ abgebildet wird. Dieses Differenz-Datenwort hat die Rangfolgenummer 4, das abgebildete höchste relevante Datenbit hat die Bitposition 4. Als Rest nach der Abbildung verbleibt das Differenz-Datenwort $100_2$ mit der Rangfolgenummer 3 (=4-1), die der Anzahl der Bitpositionen entspricht. Unter der Annahme, dass bei einer gleichen Anzahl von Bitpositionen der noch zu codierenden Differenz-Datenworte das Differenz-Datenwort des zu codierenden Wertes dY bevorzugt wird, wird als nächstes das Datenbit $Y_2=1$ des Differenzwertes $1100_2$, das die Bitposition 3 hat abgebildet. Das verbleibende Differenz-Datenwort $00_2$ erhält die Rangfolgenummer 2. Nun stehen sich das Differenz-Datenwort $00_2$ von dY mit der Rangfolgenummer 3 bzw. mit zwei Bitpositionen und das Differenz-Datenwort $100_2$ von dC mit der Rangfolgenummer 3 bzw. mit drei Bitpositionen gegenüber, so dass als nächstes das Bit an der höchsten Bitposition dieses Wertes $100_2$ codiert wird.

Dieses Vorgehen zur Codierung der Differenzwerte zwischen dem zu codierenden Datenwert und dem jeweiligen Approximationswert wird so lange fortgesetzt, bis eine der oben erläuterten Bedingungen erreicht ist, bis also alle Datenbits der Differenzen abgebildet sind, oder eine vorgegebene Anzahl Datenbits des codierten Wortes erreicht ist oder jeweils ein minimaler Codierungsfehler für jeden Datenwert erreicht ist. Unter Annahme der Endbedingung, dass alle Datenbits der ersten und zweiten Datenwerte codiert werden, ist das Codierverfahren in Figur 11b zusammengefasst.

Selbstverständlich besteht auch bei diesem Verfahren die Möglichkeit, einem der zu codierenden Datenworte bzw. einem der nach Codierung des Approximationswertes zu codierenden Differenz-Datenworte eine Codierungspriorität zuzuweisen und bei Vergleich der Rangfolgenummern solange das priorisierte Differenz-Datenwort auszuwählen und dessen jeweiliges Datenbit zu codieren, so lange dessen Rangfolgenummer um weniger als einen vorgegebenen Wert die Rangfolgenummer des wenigstens einen anderen Differenz-Datenwortes übersteigt.

Die einzelnen Approximationswerte können bezugnehmend auf die Tabelle in Figur 11a so gewählt, dass der ihnen zugeordnete maximale Fehler mit zunehmendem Betrag der Approximationswerte gleich bleibt oder zunimmt, was gleichbedeutend damit ist, dass die Differenz zu dem jeweils nächstgrößeren Approximationswert mit zunehmenden Beträgen der Approximationswerte gleich bleibt oder größer wird.

Es besteht jedoch auch die Möglichkeit, dass die Abstände zwischen einzelnen Approximationswerten für größer werdende Approximationswerte kleiner werden.

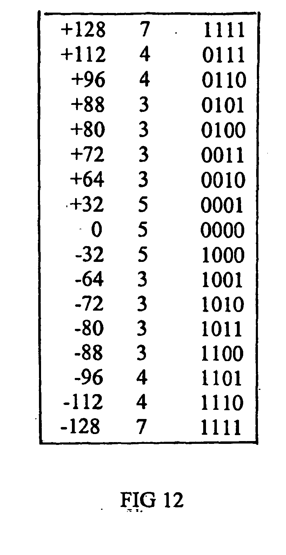

Des weiteren besteht die Möglichkeit den Abstand zwischen einzelnen Approximationswerten einer Gruppe mit wenigstens zwei Approximationswerten kleiner zu wählen, als den Abstand zwischen dem betragsmäßig kleinsten der Approximationswerte dieser Gruppe und dem nächstkleineren Approximationswert und dem Abstand zwischen dem betragsmäßig größten der Approximationswerte dieser Gruppe und dem nächstgrößeren Approximationswert. Dieses Vorgehen ist insbesondere dann sinnvoll, wenn zu erwarten ist, dass die zu codierenden Datenwerte häufig Werte annehmen, die im Bereich der Approximationswerte dieser Gruppe liegen. Solche Werte werden bei dem erfindungsgemäßen Verfahren bereits in dem ersten Schritt, bei dem ein Approximationswert aus der Tabelle ausgewählt wird, mit einem geringen Fehler approximiert. Figur 12 zeigt anhand einer Tabelle ein Beispiel für eine solche Folge mit Approximationswerten. In der linken Spalte sind dabei die Approximationswerte (0, $\pm32$, $\pm64$, $\pm80$, $\pm96$, $\pm112$, $\pm144$), in der mittleren Spalte die zugeordneten Rangfolgenummern und in der rechten Spalte sind die den Approximationswerten zugeordneten Codeworte angegeben, die jeweils eindeutig für die einzelnen Approximationswerte sind.

Die Tabelle enthält eine Gruppe von vier Approximationswerten $\pm64$, $\pm72$, $\pm80$, $\pm88$ von denen

sich zwei benachbarte jeweils um 8 unterscheiden und denen die Rangfolgenummer 3 zugeordnet ist. Der Abstand, d.h. der Betrag der Differenz, zwischen dem betragsmäßig kleinsten Approximationswert ±64 und dem betragsmäßig nächstkleineren Approximationswert ±32 beträgt 32, was gleichbedeutend damit ist, dass dieser nächstkleinere Approximationswert ±32 die Rangfolgenummer 5 besitzt. Der Abstand zwischen dem zu dieser Gruppe nächstgrößeren Approximationswert ±96 und dessen betragsmäßig größerem Approximationswert ±112 beträgt 16 wodurch dieser Approximationswert ±96 die Rangfolgenummer 4 besitzt.

Diese Wahl der Approximationswerte ist insbesondere dann sinnvoll, wenn zu erwarten ist, dass die Beträge der zu codierenden Datenwerte häufig Werte im Bereich zwischen 64 und 88 annehmen.

Bei den zuvor erläuterten Verfahren besitzen die ersten Codewörter, die den Bitpositionen des ersten Datenwortes zugeordnet sind, jeweils eine gleiche Wortlänge, und die ersten Codewörter, die den Bitpositionen des zweiten Datenwortes zugeordnet sind, besitzen jeweils gleich Wortlänge. Bei einer weiteren Ausführungsform des Verfahrens ist vorgesehen, die ersten und/oder zweiten Codewörter so zu wählen, dass sie eine unterschiedliche Wortlänge besitzen. Die Codewörter, die den einzelnen Bitpositionen zugeordnet sind, sind dabei vorzugsweise abhängig von der Häufigkeit gewählt, mit der die einzelnen Bitpositionen durch das jeweils höchste relevante Datenbit eines Datenwortes besetzt sind. Bitpositionen, die häufiger als andere Bitpositionen die höchste relevante Bitposition bilden, sind dabei kürzere Codewörter als den anderen Bitpositionen zugeordnet, um insgesamt für die Codierung häufig vorkommender Datenworte ein kürzeres codiertes Datenwort zu erhalten. Ein derartiges Vorgehen, für die Übertragung von Information abhängig von der Auftrittswahrscheinlichkeit der zu übertragenden Information unterschiedlich lange Codewörter zu verwenden ist hinlänglich bekannt und beispielsweise in Proakis, John G.:"Digital Communications", 3. Auflage, Mc Graw-Hill, ISBN 0-07-051726-6, Seiten 95 bis 103 beschrieben. Diese Art der Codierung wird als variable Längencodierung bezeichnet.

In der vorherigen Erläuterung wurden verschiedene Codierungstabellen für die Codierung des relevantesten Signalanteils erläutert. Es sei darauf hingewiesen, dass auch die Möglichkeit besteht, unterschiedliche Codierungstabellen vorzusehen und abhängig von der Signalstatistik, d.h. abhängig von der Häufigkeit des Vorkommens bestimmter zu codierender Werte in der Signalfolge, eine der Codierungstabellen für die Codierung auszuwählen.

Des weiteren sei darauf hingewiesen, dass das Verfahren nicht auf die Codierung von zwei Datenwerten beschränkt ist sondern auf beliebig viele zu codierende Datenwerte anwendbar ist. Bei der Codierung der Differenz-Datenworte ist dabei festzulegen, welches der Differenz-Datenworte bei gleichen Rangfolgenummern bevorzugt codiert wird.

Das Verfahren zur empfängerseitigen Decodierung eines nach dem erfindungsgemäßen Verfahren erzeugten, codierten Datenwortes, das wenigstens einen ersten Datenabschnitt, einen zweiten Datenabschnitt und wenigstens einen zusätzlichen Datenabschnitt aufweist, um ein erstes und zweites decodiertes Datenwort zu erhalten ergibt sich unmittelbar aus dem Codierungsalgorithmus. Hierbei werden empfängerseitig decodierte Datenworte aus den übertragenen Approximationswerten und den Datenbits der Differenz-Datenworte rekonstruiert.

**Patentansprüche**

1.    Verfahren zur Codierung eines ersten Datenwertes, der durch ein erstes Datenwort (d1) repräsentiert ist, und wenigstens eines zweiten Datenwertes, der durch ein zweites Datenwort (d2) repräsentiert ist, in ein codiertes Datenwort (d3), das folgende Verfahrensschritte umfasst:

- Ermitteln eines ersten Approximationswertes, dem ein erstes Codewort (c1) zugeordnet ist, für den ersten Datenwert, und eines zweiten Approximationswertes, dem ein zweites Codewort (c2) zugeordnet ist, für den zweiten Datenwert, wobei eine Anzahl Approximationswerte vorgegeben sind, und wobei als Approximationswert für einen Datenwert der Approximationswert aus der Anzahl der Approximationswerte ausgewählt wird, der kleiner als der Datenwert ist und der sich im Vergleich zu weiteren der Approximationswerte betragsmäßig am wenigsten von dem Datenwert unterscheidet,
- Abbilden des ersten Codewortes (c1) auf einen ersten Datenabschnitt des codierten Datenwortes (d3) und Abbilden des zweiten Codewortes (c2) auf einen zweiten Datenabschnitt des codierten Datenwortes,
- Ermitteln einer ersten Differenz zwischen dem ersten Datenwert und dem ersten Approximationswert und Ermitteln einer zweiten Differenz zwischen dem zweiten Datenwert und dem zweiten Approximationswert und wenigstens teilweises Abbilden eines den ersten Differenzwert repräsentierenden ersten Differenz-Datenwortes und/oder eines den zweiten Differenzwert repräsentierenden zweiten Differenz-Datenwortes auf wenigstens einen zusätzlichen Datenabschnitt des codierten Datenwortes (d3), und wobei jedem der Approximationswerte eine Rangfolgenummer zugeordnet ist, die abhängig ist vom Betrag der Differenz zwischen einem der Approximationswerte und dem betragsmäßig nächstgrößeren oder nächstkleineren der Approximationswerte, wobei

die Rangfolgenummern der Approximationswerte verglichen werden und abhängig von diesem Vergleich ein Datenbit des ersten oder zweiten Datenwortes (d1, d2) auf den zusätzlichen Datenabschnitt abgebildet wird.

2. Verfahren nach Anspruch 1, bei dem wenigstens einige der Approximationswerte keine Potenzen der Zahl 2 sind.

3. Verfahren nach Anspruch 1 oder 2, bei dem sich ein Approximationswert von dem nächstgrößeren der Anzahl der Approximationswerte jeweils um eine Potenz der Zahl 2 unterscheidet.

4. Verfahren nach einem der Ansprüche 1 bis 3, bei dem die Rangfolgenummer mit größer werdendem Betrag der Differenz größer wird.

5. Verfahren nach Anspruch 4, bei dem die Rangfolgenummer der Anzahl der Bitpositionen entspricht, die erforderlich sind, um den Betrag der Differenz als binäres Datenwort darzustellen.

6. Verfahren nach einem der Ansprüche 4 oder 5, bei dem in der Anzahl der Approximationswerte eine Gruppe von wenigstens zwei Approximationswerten existiert, von denen zwei benachbarte Approximationswerte jeweils einen Abstand besitzen, wobei dieser Abstand kleiner ist als der Abstand zwischen dem betragsmäßig kleinsten der Approximationswerte dieser Gruppe und dem nächstkleineren Approximationswert und kleiner ist als der Abstand zwischen dem betragsmäßig größten Approximationswert dieser Gruppe und dem nächstgrößeren Approximationswert.

7. Verfahren nach einem der vorhergehenden Ansprüche, bei dem dem ersten Differenz-Datenwort die Rangfolgenummer des ersten Approximationswertes und dem zweiten Differenz-Datenwort die Rangfolgenummer des zweiten Approximationswertes zugeordnet wird und das folgende weitere Verfahrensschritte aufweist:

   a) Vergleichen der Rangfolgenummern des ersten und zweiten Differenz-Datenwortes,
   b) Auswählen eines Differenz-Datenworts aus dem ersten und dem wenigstens einen zweiten Differenz-Datenwort abhängig von diesem Vergleich,
   c) Abbilden des Datenbits der höchsten relevanten Bitposition des in Schritt b) ausgewählten Differenz-Datenworts auf eine Bitposition des zusätzlichen Datenabschnitts.

8. Verfahren nach Anspruch 7, das folgende weitere Verfahrensschritte umfasst:

   d) Reduzieren der Rangfolgenummer des ausgewählten Differenz-Datenwortes um einen vorgegebenen Wert und Bilden eines neuen Differenz-Datenwortes aus dem ausgewählten Datenwort durch Streichen der höchsten relevanten Bitposition.
   e) Wiederholen der Verfahrensschritte a) bis d) bis eine vorgegebene Endbedingung erreicht ist.

9. Verfahren nach einem der Ansprüche 7 oder 8, bei dem die Rangfolgenummer eine ganze Zahl ist und bei dem der vorgegebene Wert, um den die Rangfolgenummer reduziert wird, Eins ist.

10. Verfahren nach Anspruch 8 oder 9, bei dem im Verfahrensschritt b) das Differenz-Datenwort mit der kleinsten Rangfolgenummer ausgewählt wird.

11. Verfahren nach Anspruch 10, bei dem festgelegt ist, welches Differenz-Datenwort ausgewählt wird, wenn mehrere Differenz-Datenworte jeweils die kleinste Rangfolgenummer aufweisen.

12. Verfahren nach Anspruch 8 oder 9, bei dem einem der Datenworte von dem ersten und dem wenigstens einen zweiten Datenwort eine Codierungspriorität zugewiesen ist, wobei im Verfahrensschritt b) stets das Datenwort mit der Codierungspriorität ausgewählt wird, wenn die Differenz zwischen der Rangfolgenummer des Differenz-Datenwortes mit der Codierungspriorität und der nächstkleineren Rangfolgenummer kleiner ist als ein vorgegebener Wert.

13. Verfahren nach einem der Ansprüche 8 bis 12, bei dem die Endbedingung erfüllt ist, wenn alle zusätzlichen Datenbits des codierten Datenwortes besetzt sind.

14. Verfahren einem der Ansprüche 8 bis 12, bei dem die Endbedingung erfüllt ist, wenn ein aus der Kodierung resultierender Kodierungsfehler für wenigstens eines der wenigstens zwei Datenworte (d1, d2) unterhalb einer vorgegebenen Schwelle liegt.

15. Verfahren nach einem der Ansprüche 8 bis 12, bei dem die Endbedingung erfüllt ist, wenn von wenigstens einem der wenigstens zwei Datenworte (d1, d2) alle Datenbits auf das codierte Datenwort abgebildet sind.

16. Verfahren nach einem der vorangehenden Ansprüche, bei dem die Datenworte differentielle Datenwerte repräsentieren.

17. Verfahren nach einem der vorangehenden Ansprüche, bei dem die ersten und zweiten Datenwerte Bildinformationswerte eines Bildpunktes bei der Bildverarbeitung repräsentieren.

**18.** Verfahren nach einem der vorangehenden Ansprüche, bei dem das erste Datenwort einen Luminanzwert oder einen differentiellen Luminanzwert und das zweite Datenwort einen Chrominanzwert oder einen differentiellen Chrominanzwert repräsentiert.

**19.** Verfahren nach einem der vorangehenden Ansprüche, bei dem das ersten Datenwort und das zweite Datenwort unterschiedlich viele Datenbits umfassen.

**20.** Verfahren nach einem der vorangehenden Ansprüche, bei dem alle ersten Codewörter eine gleiche Anzahl Codebits umfassen und/oder bei dem alle zweiten Codewörter eine gleiche Anzahl Codebits umfassen.

**21.** Verfahren nach einem der vorangehenden Ansprüche, bei dem die Anzahl der Codebits der ersten Codewörter variiert und/oder bei dem Anzahl der Codebits der zweiten Codewörter variiert.

**Claims**

**1.** A process for encoding a first data value represented by a first data word (d1) and at least one second data value represented by a second data word (d2) into an encoded data word (d3), comprising the following process steps:

- determining a first approximation value having allocated thereto a first code word (c1) for the first data value and a second approximation value having allocated thereto a second code word (c2) for the second data value, with a number of approximation values being specified, and wherein as an approximation value for a data value that approximation value is selected from the number of approximation values, which is smaller than the data value and has the smallest amount of difference from the data value compared to further ones of the approximation values,
- mapping the first code word (c1) onto a first data section of the encoded data word (d3) and mapping the second code word (c2) onto a second code section of the encoded data word,
- determining a first difference between the first data value and the first approximation value and determining a second difference between the second data value and the second approximation value and at least partially mapping a first difference data word representing the first difference value and/or a second difference data word representing the second difference value onto at least one additional data section of the encoded data word (d3), and wherein a ranking number is allocated to each of the approximation values, which is a function of the amount of difference between one of the approximation values and the approximation value with the next higher or next lower amount, wherein

the ranking numbers of the approximation values are compared with each other and, as a function of this comparison, a data bit of the first or the second data word (d1, d2) is mapped onto the additional data section.

**2.** The process as claimed in Claim 1, wherein at least some of the approximation values are not powers of the number 2.

**3.** The process as claimed in Claim 1 or 2, wherein an approximation value differs in each case from the next higher one of the number of approximation values by a power of the number 2.

**4.** The process as claimed in any one of Claims 1 to 3, wherein the ranking number increases with the increasing amount of the difference.

**5.** The process as claimed in Claim 4, wherein the ranking number corresponds to the number of bit positions required to represent the amount of the difference as a binary data word.

**6.** The process as claimed in one of Claims 4 and 5, wherein a group of at least two approximation values exists amongst the number of approximation values, of which two neighbouring approximation values have a distance and this distance is smaller than the distance between the approximation value with the smallest amount in this group and the approximation value with the next smaller amount and is smaller than the distance between the approximation value with highest amount in this group and the approximation value with the next higher amount.

**7.** The process as claimed in any one of the preceding claims, wherein the first difference data word has allocated thereto the ranking number of the first approximation value and the second difference data word has allocated thereto the ranking number of the second approximation value, and which includes the following further process steps:

a) comparing the ranking numbers of the first and second difference data words,
b) selecting a difference data word from the first and the at least one second difference data word as a function of this comparison,
c) mapping the data bit of the highest relevant bit position of the difference data word selected in step b) onto a bit position of the additional data section.

8. The process as claimed in Claim 7, which comprises the following further process steps:

    d) reducing the ranking number of the selected difference data word by a specified value and forming a new difference data word from the selected data word by deleting the highest relevant bit position,
    e) repeating process steps a) to d) until a specified final condition is met.

9. The process as claimed in Claim 7 or 8, wherein the ranking number is an integer and wherein the specified value by which the ranking number is reduced is one.

10. The process as claimed in Claim 8 or 9, wherein in process step b) the difference data word having the lowest ranking number is selected.

11. The process as claimed in Claim 10, wherein it is established which difference data word is selected when each of several difference data words has the lowest ranking number.

12. The process as claimed in Claim 8 or 9, wherein one of the data words of the first and the at least one second data word has allocated thereto an encoding priority, wherein in process step b) the data word having the encoding priority is always selected when the difference between the ranking number of the difference data word with the encoding priority and the next lower ranking number is smaller than a specified value.

13. The process as claimed in any one of Claims 8 to 12, wherein the final condition is met if all of the additional data bits of the encoded data word are occupied.

14. The process as claimed in any one of Claims 8 to 12, wherein the end condition is met when an encoding error resulting from the encoding is below a specified threshold for at least one of the at least two data words (d1, d2).

15. The process as claimed in Claims 8 to 12, wherein the final condition is met when all of the data bits of at least one of the at least two data words (d1, d2) have been mapped onto the encoded data word.

16. The process as claimed in any one of the preceding claims, wherein the data words represent differential data values.

17. The process as claimed in any one of the preceding claims, wherein the first and second data words represent image information values of a pixel during image processing.

18. The process as claimed in any one of the preceding claims, wherein the first data word represents a luminance value or a differential luminance value and the second data word represents a chrominance value or a differential chrominance value.

19. The process as claimed in any one of the preceding claims, wherein the first data word and the second data word include different amounts of data bits.

20. The process as claimed in any one of the preceding claims, wherein all of the first data words include the same number of code bits and/or wherein all of the second code words include the same number of code bits.

21. The process as claimed in any one of the preceding claims, wherein the number of code bits of the first code words varies and/or wherein the number of code bits of the second code words varies.

## Revendications

1. Procédé de codage d'une première valeur de données représentée par un premier mot de données (d1), et d'au moins une seconde valeur de données représentée par un second mot de données (d2) en un mot de données codé (d3), procédé comprenant les étapes suivantes :

    - déterminer une première valeur approchée à laquelle est associé un premier mot de code (c1) pour la première valeur de données et une seconde valeur approchée à laquelle est associé un second mot de code (c2) pour la seconde valeur de données,

        * un certain nombre de valeurs approchées étant prévu, et
        * comme valeur approchée d'un mot de données, on sélectionne la valeur approchée parmi l'ensemble des valeurs approchées, inférieure à la valeur de données et dont l'amplitude se diffère le moins de la valeur de données par comparaison avec les autres valeurs approchées,

    - copier le premier mot de code (c1) sur un premier segment de données du mot de données codé (d3) et copier le second mot de code (c2) sur un second segment de données du mot de données codé,

- déterminer une première différence entre la première valeur de données et la première valeur approchée et déterminer une seconde différence entre la seconde valeur de données et la seconde valeur approchée et copier au moins en partie un premier mot de données de différence représentant la première valeur de différence et/ou un second mot de données de différence représentant la seconde valeur de différence sur au moins un segment de données supplémentaire du mot de données (d3), codé, et

    * à chaque valeur approchée, on associe un numéro d'ordre dépendant de l'amplitude de la différence entre l'une des valeurs approchées et la valeur approchée d'amplitude directement plus grande, et la valeur approchée d'amplitude directement plus petite,
    * on compare les numéros d'ordre des valeurs approchées et en fonction de cette comparaison, on copie un bit de données du premier ou du second mot de données (d1, d2) sur le segment de données supplémentaire.

**2.** Procédé selon la revendication 1,
selon lequel
au moins certaines des valeurs approchées, ne sont pas une puissance de 2.

**3.** Procédé selon la revendication 1 ou 2,
selon lequel
une valeur approchée diffère du nombre directement supérieur des valeurs approchées chaque fois d'une puissance du nombre 2.

**4.** Procédé selon l'une des revendications 1 à 3,
selon lequel
le numéro d'ordre augmente avec l'augmentation de l'amplitude de la différence.

**5.** Procédé selon la revendication 4,
selon lequel
le numéro d'ordre correspond au nombre de positions de bit nécessaire pour représenter l'amplitude de la différence sous la forme d'un mot de données binaire.

**6.** Procédé selon la revendication 4 ou 5,
selon lequel
le nombre des valeurs approchées, comprend un groupe d'au moins deux valeurs approchées dont deux valeurs approchées voisines ont à chaque fois une distance et cette distance est inférieure à la distance entre la valeur approchée d'amplitude la plus petite de ce groupe et la plus petite valeur approchée voisine et cette distance est inférieure à la distance entre la valeur approchée d'amplitude la plus grande de ce groupe et la valeur approchée d'amplitude directement au-dessus de cette valeur approchée.

**7.** Procédé selon l'une des revendications précédentes,
selon lequel
on associe au premier mot de données de différence, le numéro d'ordre de la première valeur approchée et au second mot de données de différence, le numéro d'ordre de la seconde valeur approchée et en ce qu'il comporte les autres étapes de procédé suivantes :

    a) comparaison des numéros d'ordre du premier et du second mot de données de différence,
    b) sélection d'un mot de données de différence parmi le premier et au moins un second mot de données de différence en fonction de cette comparaison,
    c) copie du bit de données de la position de bit caractéristique la plus élevée du mot de données de différence sélectionné dans l'étape b), sur une position de bit du segment de données supplémentaire.

**8.** Procédé selon la revendication 7,
**caractérisé en ce qu'**il comprend les autres étapes de procédé suivantes :

    d) réduction d'une valeur prédéfinie du numéro d'ordre du mot de données de différence sélectionné, et formation d'un nouveau mot de données de différence à partir du mot de données sélectionné par suppression de la position de bit caractéristique la plus élevée,
    e) répétition des étapes de procédé a) - d) jusqu'à atteindre une condition finale prédéfinie.

**9.** Procédé selon la revendication 7 ou 8,
selon lequel
le numéro d'ordre est un nombre entier et la valeur prédéfinie dont on réduit le numéro d'ordre est la valeur un.

**10.** Procédé selon la revendication 8 ou 9,
selon lequel
dans l'étape de procédé b), on sélectionne le mot de données de différence ayant le numéro d'ordre le plus petit.

**11.** Procédé selon la revendication 10,
selon lequel
on fixe le mot de données de différence sélectionné si plusieurs mots de données de différence ont respectivement le plus petit numéro d'ordre.

**12.** Procédé selon la revendication 8 ou 9, selon lequel

on attribue une priorité de codage, aux mots de données parmi le premier et au moins un second mot de données,

　　* et dans l'étape de procédé b), on sélectionne toujours le mot de données ayant la priorité de codage si la différence entre les numéros d'ordre du mot de données de différence ayant la priorité de codage et le numéro d'ordre le plus petit suivant, est inférieure à une valeur prédéfinie.

**13.** Procédé selon l'une des revendications 8 à 12, selon lequel

la condition finale est remplie si tous les bits de données supplémentaires du mot de données codé sont occupés.

**14.** Procédé selon l'une des revendications 8 à 12, selon lequel

la condition finale est remplie si une erreur de codage résultant du codage pour au moins l'un des deux mots de données (d1, d2) se situe en dessous d'un seuil prédéfini.

**15.** Procédé selon l'une des revendications 8 à 12, selon lequel

la condition finale est remplie si tous les bits de données d'au moins l'un des deux mots de données (d1, d2) sont copiés sur le mot de données codé.

**16.** Procédé selon l'une des revendications précédentes, selon lequel

les mots de données représentent des valeurs de données différentielles.

**17.** Procédé selon l'une des revendications précédentes, selon lequel

les premiers et les seconds mots de données représentent des valeurs d'informations d'image d'un point image pour un traitement d'image.

**18.** Procédé selon l'une des revendications précédentes, selon lequel

le premier mot de données est une valeur de luminance ou une valeur de luminance différentielle, et le second mot de données est une valeur de chrominance ou une valeur de chrominance différentielle.

**19.** Procédé selon l'une des revendications précédentes, selon lequel

le premier mot de données et le second mot de données, comportent un nombre différent de bits de données.

**20.** Procédé selon l'une des revendications précédentes, selon lequel

tous les premiers mots de code, ont un même nombre de bits de codage et/ou tous les seconds mots de code, ont un même nombre de bits de codage.

**21.** Procédé selon l'une des revendications précédentes, selon lequel

le nombre de bits de codage des premiers mots de code est variable et/ou le nombre de bits de codage des seconds mots de code est variable.

# FIG 1  Stand der Technik

**a)**

dY=60          dC=19

**b)**

| Luma-DPCM | |
|---|---|
| 0 | 000000 |
| 1 | 000001 |
| 2 | 000010 |
| ... | ... |
| 8 | 001000 |
| 9 | 001001 |
| 10 | 001010 |
| 12 | 001011 |
| ... | ... |
| 42 | 011010 |
| 44 | 011011 |
| 48 | 011100 |
| 52 | 011101 |
| 56 | 011110 |
| 60 | 011111 |
| 64 | 100000 |
| ... | ... |
| 124 | 101111 |
| 128 | 110001 |
| 136 | 110010 |
| 144 | 110011 |
| ... | ... |
| 240 | 111110 |
| 248 | 111111 |

| Chroma-DPCM | |
|---|---|
| 0 | 0000 |
| 1 | 0001 |
| 2 | 0010 |
| 4 | 0011 |
| 6 | 0100 |
| 8 | 0101 |
| 12 | 0110 |
| 16 | 0111 |
| 20 | 1000 |
| 24 | 1001 |
| 32 | 1010 |
| 48 | 1011 |
| 64 | 1100 |
| 96 | 1101 |
| 128 | 1110 |
| 192 | 1111 |

**c)**

dY=60          dC=19

0  011111    0  0111

↑ dY'=60   ↑ dC'=16

Sgn$_y$        Sgn$_x$

## FIG 2

d1

d2

m1

m2

d3

$n < m1 + m2$

## FIG 3

m1

$K1 =$ 7 6 5 4 3 2 1

d1

11

c1

$2^0 = 1$ → 001 · c1(1)
$2^1 = 2$ → 010 c1(2)
$2^2 = 4$ → 011 c1(3)
$2^3 = 8$ → 100 c1(4)
$2^4 = 16$ → 101 c1(5)
$2^5 = 32$ → 110 c1(6)
$2^6 = 64$ → 111 c1(7)
000 c1(0)

EP 1 631 091 B1

## FIG 4

## FIG 5

21

## FIG 6

### a)

| $d1'=$ | d1(6) | d1(5) | d1(4) | d1(3) | 0 | 0 |
|---|---|---|---|---|---|---|

$d1'_2=$ 　1　　1　　1　　1　　0　　0

$d1'=60$

### b)

| $d2'=$ | d2(5) | d2(4) | 0 | 0 | 0 |
|---|---|---|---|---|---|

$d2'_2=$ 　1　　0　　0　　0　　0

$d2'_{10}=16$

## FIG 7
### a)

d1                                    d2

| 0 | 0 | 0 | 0 | 1 | 1 | 0 |        | 0 | 0 | 1 | 0 | 0 | 1 | 1 |

$r1=K1=$ 7  6  5  4  3  2  1        $r2=K2=$ 7  6  5  4  3  2  1

$d1_{10}=6$                                    $d2_{10}=19$

d3 → | 0 | 1 | 1 | 1 | 0 | 1 | 0 | 0 | 1 | 1 |

$c1(3)$   $c1(5)$

d2(4)
d2(3)
d1(2)
d2(2)

### b)

$d1'=$ | d1(3) | d1(2) | 0 | $=110_2=6_{10}$

$d2'=$ | d2(5) | d2(4) | d2(3) | d2(1) | 0 | $=10010_2=18_{10}$

# FIG 8

# FIG 9

# FIG 10

## a)

$dY = 60$

$dC = 19$

## b)

| MSB-DPCM | | |
|---|---|---|
| -64 | 6 | 1111 |
| -32 | 5 | 1110 |
| -16 | 4 | 1101 |
| -8 | 3 | 1100 |
| -4 | 2 | 1011 |
| -2 | 1 | 1010 |
| -1 | 0 | 1001 |
| 0 | 0 | 0000 |
| +1 | 0 | 0001 |
| +2 | 1 | 0010 |
| +4 | 2 | 0011 |
| +8 | 3 | 0100 |
| +16 | 4 | 0101 |
| +32 | 5 | 0110 |
| +64 | 6 | 0111 |
| +/-128 | 7 | 1000 |

| MSB-DPCM | | |
|---|---|---|
| -64 | 6 | 1111 |
| -32 | 5 | 1110 |
| -16 | 4 | 1101 |
| -8 | 3 | 1100 |
| -4 | 2 | 1011 |
| -2 | 1 | 1010 |
| -1 | 0 | 1001 |
| 0 | 0 | 0000 |
| +1 | 0 | 0001 |
| +2 | 1 | 0010 |
| +4 | 2 | 0011 |
| +8 | 3 | 0100 |
| +16 | 4 | 0101 |
| +32 | 5 | 0110 |
| +64 | 6 | 0111 |
| +/-128 | 7 | 1000 |

## c)

$d1 = dY = 60_{10} = 001{:}11100_2$

$= dY' + 28_{10}$

$d2 = dC = 19_{10} = 0001{:}0011_2$

$= dC' + 3_{10}$

$d3 = \underbrace{0110}_{dY'} \quad \underbrace{0101}_{dC'} \quad 1 \quad 1 \quad 0 \quad 1$

$\qquad\qquad\qquad\qquad\qquad Y_4 \ Y_3 \ C_3 \ Y_2$

| | | |
|---|---|---|
| -64 | 6 | 11101 |
| -48 | 4 | 11011 |
| -32 | 4 | 11001 |
| -24 | 3 | 10111 |
| -16 | 3 | 10101 |
| -12 | 2 | 10011 |
| -8 | 2 | 10001 |
| -4 | 2 | 0111 |
| -2 | 1 | 0101 |
| -1 | 0 | 0011 |
| 0 | 0 | 000 |
| +1 | 0 | 0010 |
| +2 | 1 | 0100 |
| +4 | 2 | 0110 |
| +8 | 2 | 10000 |
| +12 | 2 | 10010 |
| +16 | 3 | 10100 |
| +24 | 3 | 10110 |
| +32 | 4 | 11000 |
| +48 | 4 | 11010 |
| +64 | 6 | 11100 |
| ±128 | 7 | 1111 |

FIG 11a

$$d1 = dY = 60_{10} = 48 + 12 \; \hat{=} \; 11010 \,|\, 1100_2$$

$$d2 = dC = 19_{10} = 16 + 3 \; \hat{=} \; 10100 \,|\, 011_2$$

$$d3 = \quad 11010 \quad 10100 \quad 1 \quad 1 \quad 0 \quad 0 \quad 1 \quad 0 \quad 1$$
$$\phantom{d3 = \quad} dY' \quad\;\; dC' \quad\;\; Y3 \; Y2 \; C2 \; Y1 \; C1 \; Y0 \; C0$$

FIG 11b

| | | | |
|---|---|---|---|
| +128 | 7 | · | 1111 |
| +112 | 4 | | 0111 |
| +96 | 4 | | 0110 |
| +88 | 3 | | 0101 |
| +80 | 3 | | 0100 |
| +72 | 3 | | 0011 |
| +64 | 3 | | 0010 |
| +32 | 5 | | 0001 |
| 0 | 5 | | 0000 |
| -32 | 5 | | 1000 |
| -64 | 3 | | 1001 |
| -72 | 3 | | 1010 |
| -80 | 3 | | 1011 |
| -88 | 3 | | 1100 |
| -96 | 4 | | 1101 |
| -112 | 4 | | 1110 |
| -128 | 7 | | 1111 |

FIG 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10007171

- US 5438635 A